# EUROPEAN PATENT APPLICATION

(11) **EP 4 361 878 A1**
(43) Date of publication of application: **01.05.2024**
(21) Application number: 23190064.8
(22) Date of filing: 07.08.2023
(51) Int. Cl.: G06F 30/333, G01R 31/28, G06F 30/394, G06F 30/398

(54) **METHODS AND APPARATUS TO ELEVATE CIRCUIT NODES**

(30) Priority: 31.10.2022 US 202217977666
(71) Applicant: INTEL Corporation, Santa Clara, CA 95054 (US)
(72) Inventor: HACK, Paul, Portland, 97225 (US); ZICKEL, Scot, Hillsboro, 97124 (US); GIACOBBE, John, El Dorado Hills, 95762 (US); ZAND, Koby, Santa Clara, 95054 (US); RONEN, Ilan, 42937 Hadera (IL); TSUKERMAN, Leonid, Santa Clara, 95054 (US); JIMENEZ CHAVEZ, Carlos Alberto, Santa Clara, 95054 (US)
(74) Representative: HGF

(57) **Abstract**

Methods, apparatus, systems, and articles of manufacture are disclosed. An example apparatus includes interface circuitry to obtain circuitry logic, the circuitry logic including a plurality of circuit elements logically connected by a plurality of nodes; identifier circuitry to: identify a node within the plurality of nodes for elevation; and identify a layer of an integrated circuit; port adder circuitry to modify the circuitry logic by adding a signal port, the signal port corresponding to a physical terminal in the identified layer; connector circuitry to modify the circuitry logic by connecting the signal port to the identified node; and layout planner circuitry to determine a layout of the integrated circuit based on the modified circuitry logic.

## Description

### FIELD OF THE DISCLOSURE

This disclosure relates generally to integrated circuits and, more particularly, to methods and apparatus to elevate circuit nodes.

### BACKGROUND

An integrated circuit (IC) refers to a set of electronic components that are implemented on a single piece of semiconductor material. ICs are used in a wide variety of electric devices due to their modular and compact nature. As newer devices seek to provide greater amounts of functionality than legacy devices, industry members aim to develop smaller sized electrical components for use on ICs. Smaller components increase scalability and provide space for a greater number of computational resources to be implemented on an IC per unit area of semiconductor material.

### BRIEF DESCRIPTION OF THE DRAWINGS

FIG. 1 is an example block diagram of an integrated circuit (IC) development system.
FIG. 2A is an illustrative example of an IC package manufactured using front side power delivery techniques.
FIG. 2B is an illustrative example of the IC package manufactured of FIG. 1 using back side power delivery techniques.
FIG. 3 is an example block diagram of the example designer circuitry of FIG. 1.
FIG. 4 is a first illustrative example of buffer elevator circuitry of FIG. 3.
FIG. 5 is a second illustrative example of the buffer elevator circuitry of FIG. 3.
FIG. 6 is a first illustrative example of a circuit diagram.
FIG. 7 is a second illustrative example of a circuit diagram.
FIG. 8 is flowchart representative of example machine readable instructions and/or example operations that may be executed by example processor circuitry to implement the IC development system of FIG. 1.
FIG. 9 is a flowchart representative of example machine readable instructions and/or example operations that may be executed by example processor circuitry to implement the designer circuitry of FIG. 3.
FIG. 10 is a block diagram of an example processing platform including processor circuitry structured to execute the example machine readable instructions and/or the example operations of FIG. 9 to implement the designer circuitry of FIG. 3.
FIG. 11 is a block diagram of an example implementation of the processor circuitry of FIG. 4.
FIG. 12 is a block diagram of another example implementation of the processor circuitry of FIG. 4.
FIG. 13 is a block diagram of an example software distribution platform (e.g., one or more servers) to distribute software (e.g., software corresponding to the example machine readable instructions of FIG. 9) to client devices associated with end users and/or consumers (e.g., for license, sale, and/or use), retailers (e.g., for sale, re-sale, license, and/or sub-license), and/or original equipment manufacturers (OEMs) (e.g., for inclusion in products to be distributed to, for example, retailers and/or to other end users such as direct buy customers).

In general, the same reference numbers will be used throughout the drawing(s) and accompanying written description to refer to the same or like parts. The figures are not to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of a semiconductor device, "above" is not with reference to Earth, but instead is with reference to a bulk region of a base semiconductor substrate (e.g., a semiconductor wafer) on which components of an integrated circuit are formed. Specifically, as used herein, a first component of an integrated circuit is "above" a second component when the first component is farther away from the bulk region of the semiconductor substrate than the second component.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly that might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified in the below description. As used herein "substantially real time" refers to occurrence in a near instantaneous manner recognizing there may be real world delays for computing time, transmission, etc. Thus, unless otherwise specified, "substantially real time" refers to real time +/-1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "processor circuitry" is defined to include (i) one or more special purpose electrical circuits structured to perform specific operation(s) and including one or more semiconductor-based logic devices (e.g., electrical hardware implemented by one or more transistors), and/or (ii) one or more general purpose semiconductor-based electrical circuits programmable with instructions to perform specific operations and including one or more semiconductor-based logic devices (e.g., electrical hardware implemented by one or more transistors). Examples of processor circuitry include programmable microprocessors, Field Programmable Gate Arrays (FPGAs) that may instantiate instructions, Central Processor Units (CPUs), Graphics Processor Units (GPUs), Digital Signal Processors (DSPs), XPUs, or microcontrollers and integrated circuits such as Application Specific Integrated Circuits (ASICs). For example, an XPU may be implemented by a heterogeneous computing system including multiple types of processor circuitry (e.g., one or more FPGAs, one or more CPUs, one or more GPUs, one or more DSPs, etc., and/or a combination thereof) and application programming interface(s) (API(s)) that may assign computing task(s) to whichever one(s) of the multiple types of processor circuitry is/are best suited to execute the computing task(s).

### DETAILED DESCRIPTION

A major limitation in further reducing the size and increasing scalability of ICs are interconnects. An interconnect refers to a structure that connects two or more circuit elements together electrically in an IC. To construct an IC, electrical components such as transistors, capacitors, etc. are fabricated on a wafer material. In many examples, electrical components are also referred to as circuit elements. As used above and herein, the terms " electrical components" and "circuit elements" may be used interchangeably.

In some examples, the layer of circuit elements in an IC may be referred to as the transistor layer. In many ICs, the circuit elements are positioned in a dense configuration such that there is not enough space for all the required interconnects on the transistor layer. As a result, IC manufacturers build interconnects into vertical layers above the circuit elements.

To enable scalability, manufactures seek to decrease the size of both circuit elements and their interconnects. However, the resistance of copper within the interconnect increases exponentially as the size of the interconnect decreases. The increased resistance of interconnects limits the electron flow and the overall performance of the IC.

One example of interconnects as a limiting factor in IC design is front side power delivery. Front side power delivery refers to a technique where ICs are formed by stacking various conducting layers and insulating layers onto a front side of a silicon wafer. To provide power to the various conducting layers and form an active circuit, front side power delivery techniques implement a power delivery network on the front side of the silicon wafer. A power delivery network refers to a system of interconnects dedicated to providing power (i.e., a supply current and voltage) to various circuit elements. In front side power delivery, interconnects dedicated to providing power and interconnects dedicated to carrying electrical signals between components are implemented in the same set of vertical layers.

To make room for both power and signal dedicated interconnects, some IC manufacturers have increased the number of vertical layers above the circuit elements. However, when a power interconnect extends from a lower layer to a higher layer, a voltage drop occurs due to increased resistance from a conducting via that spans the insulating layer between interconnects. As the number of vertical layers for interconnects increases the voltage drop between each layer accumulates. As a result, ICs designed using front side power delivery techniques are limited to a certain size of components and number of layers before the cumulative voltage drop noticeably decreases the available power and performance of upper metal layers.

To overcome the size and performance limitations of front side power delivery, manufacturers have begun to develop backside power delivery techniques. In a backside power delivery technique, IC layers can be bonded to both sides of a silicon wafer. Specifically, interconnects and other components of the power delivery network may be implemented on the back side of the wafer and connect through the wafer to the circuit elements. Such an architecture mitigates the need for power interconnects and signal interconnects in the same set of vertical layers. As a result, backside power delivery techniques have more space per vertical layer available for signal interconnect. With more space available, IC manufacturers can increase the number of signal interconnects per layer, thereby improving performance, without decreasing the size of the interconnects and encountering resistance issues.

In addition to minimizing the size of electrical components, an important part of IC design is verifying that the fabricated IC functions as expected. In many examples, verifying the functionality of a fabricated IC may include determining the voltages at one or more interconnects and performing debugging analysis with the corresponding values. IC manufacturers may use sensor tools such as optical probes and/or focused-ion-beams (FIBs) to determine the voltages of an interconnect. When testing an IC, various obstructions may limit a sensor tool from detecting and sensing a desired interconnect. Such obstructions may include, but are not limited to, other layers of material within the IC under test, packaging materials that house the IC under test, a second IC that is physically located between the sensor tool and the IC under test, etc. As a result, a sensor's ability to detect an interconnect and accurately read a voltage generally decreases as the physical distance between the sensor and the interconnect increases.

ICs manufactured using front side power delivery techniques may be attached to external circuitry (e.g., a motherboard) using flip chip methods. In a flip chip method, an IC is attached to external circuitry in a manner that minimizes the physical distance between the transistor layers of the IC and the sensor tools used for debugging. As a result, sensor tools can effectively access signal interconnects and determine voltages for ICs manufactured using front side power delivery. In some examples, flip chip methods of connecting an IC to external circuitry may be referred to as controlled collapse chip connection (C4).

In contrast, ICs manufactured with backside power delivery techniques may not be able to implement flip chip methods. This limitation occurs because the power delivery network, which is implemented on the backside of the wafer, may require direct connection to the external circuitry for proper functionality. Without the flip chip method, the transistor layer of ICs and some signal interconnects may be positioned farther away from sensor tools in a backside power delivery fabrication than they otherwise would be in a frontside power delivery fabrication. The increased distance of signal interconnects from the sensor tools causes challenges in that previous solutions are unable to ensure ICs manufactured using back side power delivery are properly debugged and verified.

Example methods, apparatus, and systems described herein improve the debugging and verification capabilities of backside power delivery techniques by modifying circuit designs to elevate selected circuit nodes. Furthermore, example methods, apparatus, and systems described herein improve the debugging and verification capabilities of any IC that is implemented in a manner or configuration that results in obstructions between an identified interconnect and a sensor tool. As used herein, a circuit node corresponds to a point of connection between two more circuit elements. As used herein, a circuit node may be referred to as a node, for simplicity. In some examples, a node may also be referred to as a net.

An elevated node described in examples herein may be implemented over a greater number of IC layers than a logically equivalent node from an unmodified circuit design. Advantageously, when implemented within a backside power delivery design, or within any IC that exhibits obstructions between an identified interconnect and a sensor tool, the elevated node may be close enough to a sensor tool for any signal on the node to be detected and accurately recorded for debugging.

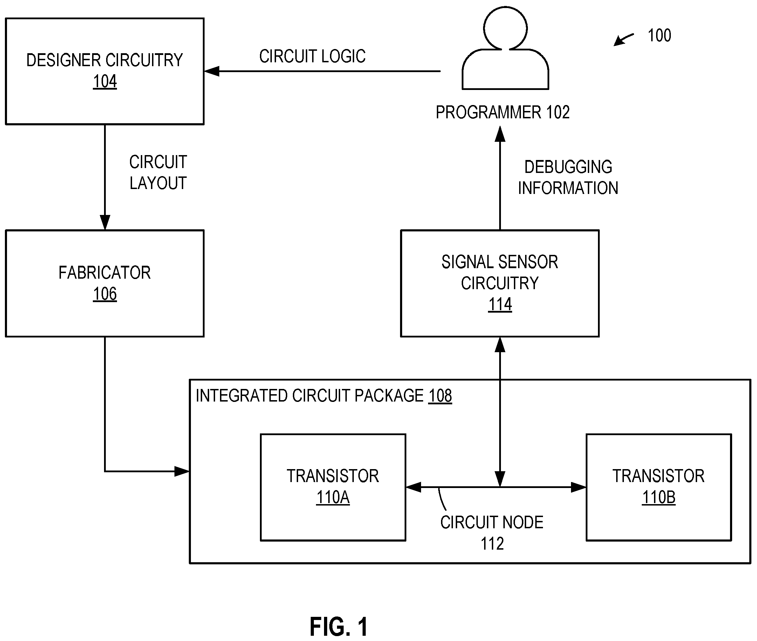

FIG. 1 is an example block diagram of an IC development system. The example system 100 includes an example programmer 102, example designer circuitry 104, an example fabricator 106, and an example IC package 108. The example IC package 108 includes example transistors 110A, 110B, and an example node 112. The example system 100 also includes example signal sensor circuitry 114.

The example programmer 102 is an individual who generates circuitry logic. As used herein, circuitry logic refers to a functional description of a circuit. For example, circuitry logic may include a list of the electronic components in a circuit, the properties of the electronic components and a list of the nodes they are connected to. In some examples, the circuitry logic may be referred to as a net list. The circuitry logic may describe which terminals of the electrical components are connected to one another but may not describe where the terminals will be physically located in the final IC. Examples of terminals in electrical components may include, but are not limited to, a gate, source, or drain of a transistor, a cathode or an anode of a diode, a capacitor, a voltage source, etc. The example programmer 102 also identifies a subset of nodes within the circuitry logic. When the circuit is in operation, the identified subset of nodes experience voltages which the example programmer 102 considers important for debugging the circuit design and verifying the IC fabrication process.

The example designer circuitry 104 generates circuit layouts. A circuit layout refers to a set of instructions that may be used to fabricate a physical IC. A circuit layout may include, but is not limited to, the size and position of circuit elements within the layers, the routes of interconnects across one or more layers, the types of materials to be used to construct the layers, a number of layers of the IC, etc.

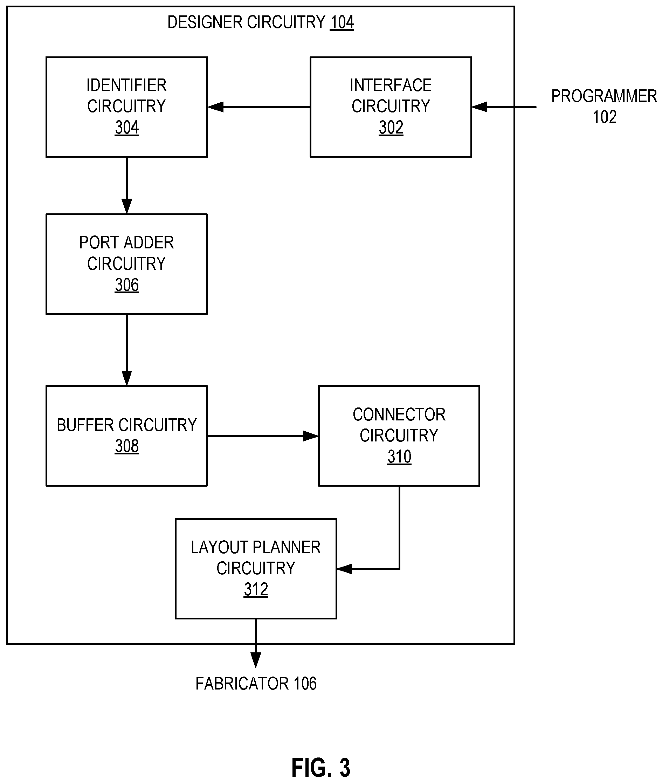

The example designer circuitry 104 produces a circuit layout based on a modified version of the circuitry logic. Specifically, the example designer circuitry 104 modifies the circuit layout to elevate the identified subset of connections to higher layers of the IC. As used above and herein, a higher or elevated layer refers to a layer of material that is closer to the example signal sensor circuitry 114 than some comparison layer. The example designer circuitry 104 is explored more in FIG. 3.

The example fabricator 106 fabricates the IC package 108 based on the circuit layout generated by the example designer circuitry 104. The example fabricator 106 fabricates the IC package 108 using back power delivery techniques. In general, the example fabricator 106 may fabricate the IC package 108 by adding layers of material onto a wafer, masking selective portions of the surface, doping regions of the materials with electrically active impurities, and heating the structure to adjust the electrical properties of the layer.

The example fabricator 106 may use any number of additional or alternative fabrication techniques to fabricate the IC package 108 with back power delivery. Example fabrication techniques include but are not limited to surface passivation, photolithography, ion implantation, etching, plasma ashing, thermal annealing, chemical or physical vapor deposition, wafer bonding, wafer bumping, wafer dicing, flip chip bonding, molding, electroplating, etc. In some examples, the example fabricator 106 may be implemented by a system of semiconductor manufacturers. In such examples, the semiconductor manufacturers may each use one or more fabrication techniques to complete one or more steps in the fabrication process based on the circuit layout generated by the example designer circuitry 104.

The example IC package 108 is a physical implementation of the modified circuitry logic. The example IC package 108 implements a plurality of electrical components that include the example transistors 110A, 110B. To connect the electrical components, the IC package implements the nodes as interconnects that extends through one or more layers of material. The interconnects include the example node 112 to connect example transistors 110A, 110B.

After fabrication, the example IC package 108 may perform a series of operations as part of a test for accuracy and functionality. The example signal sensor circuitry 114 detects interconnects within the example IC package 108 and records their voltages during the test. For example, the signal sensor circuitry 114 may record the voltage at the example node 112 at one or more points throughout the test. The example signal sensor circuitry 114 may be implemented by optical probes, focused-ion-beams (FIBs), and/or other types of IC testing systems. In some examples, the signal sensor circuitry 114 may be referred to as a probe. In some examples, the signal sensor circuitry 114 may additionally or alternatively determine other electrical characteristics of the example node 112 besides voltage.

The example signal sensor circuitry 114 requires line of site with an interconnect to accurately record voltages. While some types of example signal sensor circuitry 114 can use various techniques to physically expose certain layers of an IC and obtain line of site, the complexity of the IC makes line of site to bottom layers (i.e., layers closest to the silicon wafer) infeasible. Therefore, the example signal sensor circuitry 114 may only be able to detect voltages in the *n* layers of IC material that are closest to the sensor. As used previously, n is a positive integer that may change based on the type of signal sensor circuitry 114. In some examples, an IC layer may be referred to as observable if it is close enough to the signal sensor circuitry 114 for accurate voltage measurement. The example signal sensor circuitry 114 provides the voltages to the programmer 102, who uses the values as debugging information. For example, the programmer 102 may change the circuitry logic to correct an error in the IC functionality identified by the debugging information.

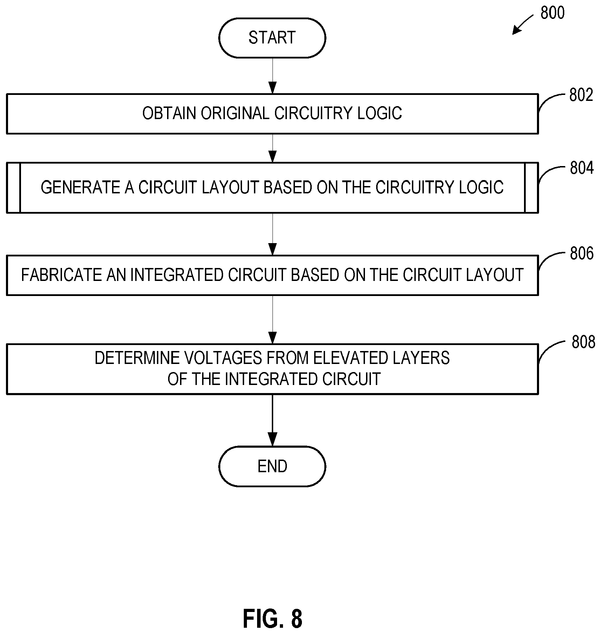

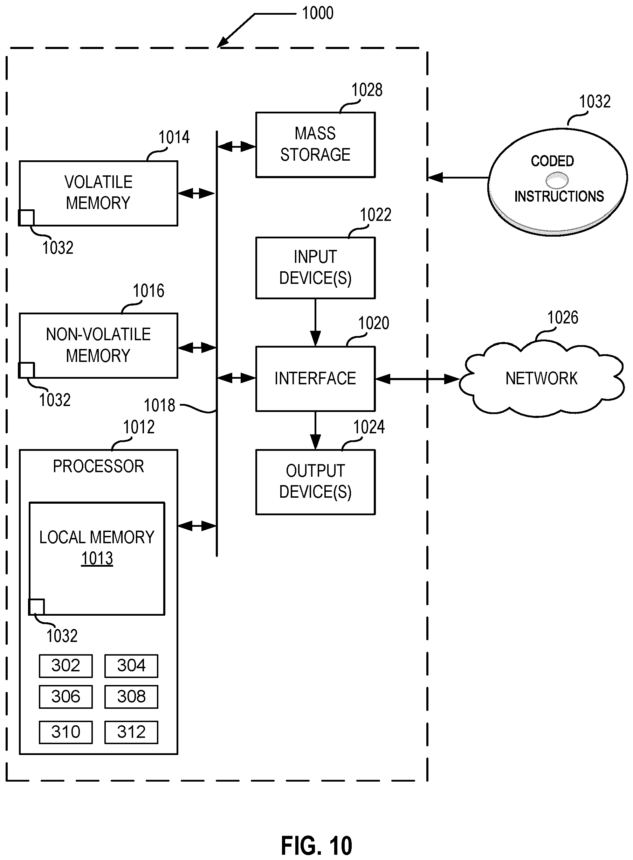

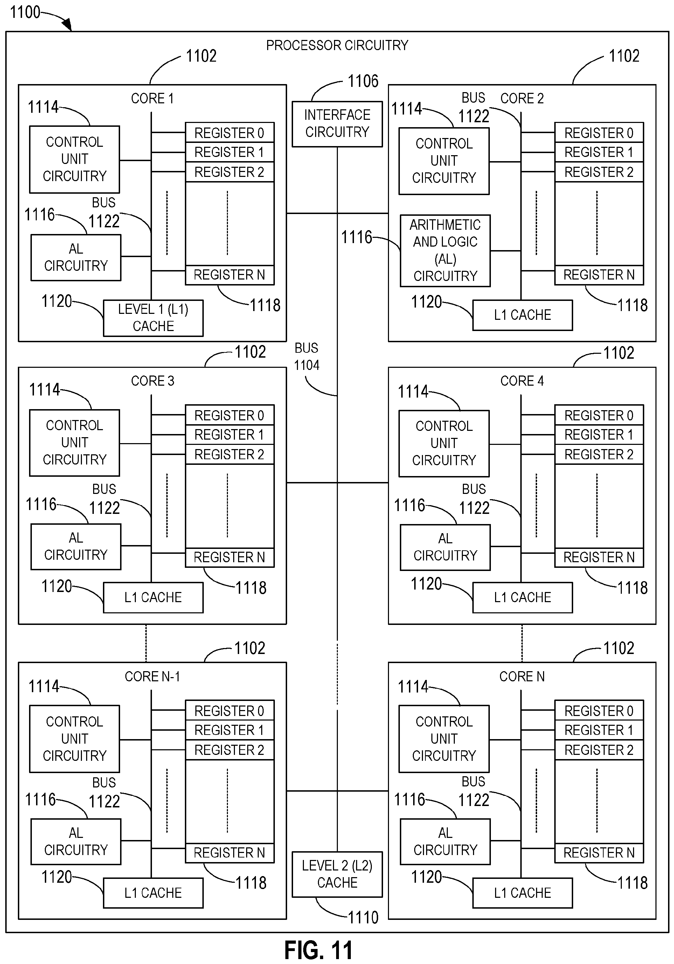

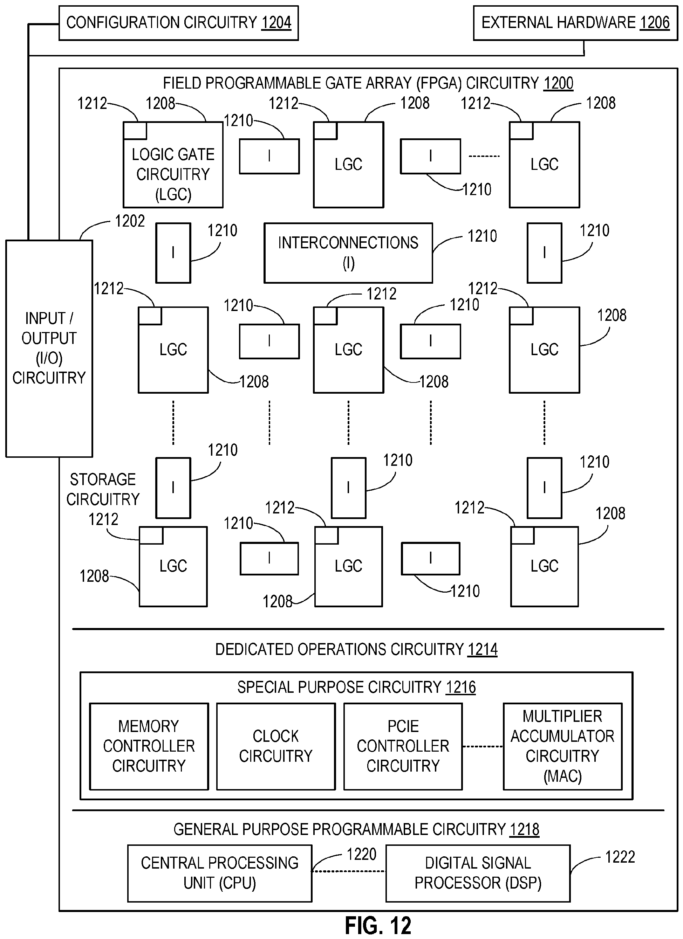

In some examples, the example system 100 includes means for sensing a voltage. For example, the means for sensing may be implemented by signal sensor circuitry 114. In some examples, the signal sensor circuitry 114 may be instantiated by processor circuitry such as the example processor circuitry 1012 of FIG. 10. For instance, the signal sensor circuitry 114 may be instantiated by the example microprocessor 1100 of FIG. 11 executing machine executable instructions such as those implemented by at least blocks 808 of FIG. 8. In some examples, the signal sensor circuitry 114 may be instantiated by hardware logic circuitry, which may be implemented by an ASIC, XPU, or the FPGA circuitry 1200 of FIG. 12 structured to perform operations corresponding to the machine readable instructions. Additionally or alternatively, the signal sensor circuitry 114may be instantiated by any other combination of hardware, software, and/or firmware. For example, the signal sensor circuitry 114 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) structured to execute some or all of the machine readable instructions and/or to perform some or all of the operations corresponding to the machine readable instructions without executing software or firmware, but other structures are likewise appropriate.

The example designer circuitry 104 modifies circuitry logic such that example IC package 108 is fabricated with elevated interconnects. An elevated interconnect is one that connects two components through a first layer of material based on the modified circuitry logic. In contrast to the elevated interconnect of the example system 100, a traditional interconnect produced in previous solutions may connect two components through a second, different layer of material based on the original circuitry logic. The elevated interconnect of the example system 100 and the traditional interconnect may be logically equivalent and perform the same function. However, because the example IC package 108 is manufactured using back power delivery techniques, the transistors in the IC package 108 are further away from the example signal sensor circuitry 114 than they would be if the example IC package 108 was manufactured using front side delivery techniques. In turn, the second layer of material accessed by traditional interconnects in previous solutions may be outside the range of the n closest layers to the example signal sensor circuitry 114. As a result, some traditional interconnect produced by previous solutions may not be accessible for accurate measurements.

Advantageously, the example designer circuitry 104 modifies the circuitry logic such that the first layer containing the elevated interconnect is within the n closest layers to the example signal sensor circuitry 114. As a result, the example system 100 ensures that any node identified by the example programmer 102 will be close enough to the example signal sensor circuitry 114 for accurate measurement and testing, even when the example IC package 108 is fabricated using backside power delivery techniques and/or is fabricated and positioned in any manner that results in obstructions between an identified interconnect and the signal sensor circuitry 114.

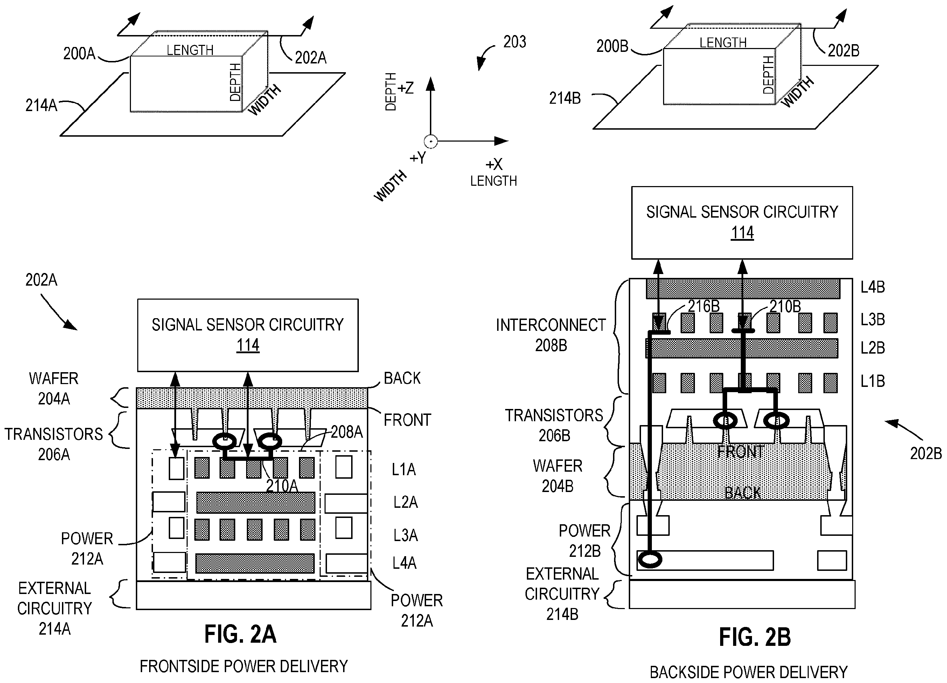

FIG. 2A is an illustrative example of an IC package manufactured using front side power delivery techniques. FIG. 2A includes the example signal sensor circuitry 114, an example IC 200A, an example view 202A, example axes 203, and example external circuitry 214A. The example view 202A includes an example wafer 204A, example transistors 206A, example signal interconnects 208A, example signal interconnect 21 0A, and example power interconnects 212A.

The example IC 200A is an IC fabricated using front side delivery techniques. The example IC 200A is illustrated as a rectangular prism in FIG. 2A to visually indicate that the example IC 200A is a 3-dimensional object. The dimensions are labelled on the example IC 200A as length, width, and depth.

The example view 202A is a cross sectional view of the example IC 200A. The example view 202A visually illustrates two of the three dimensions of the example IC 200A. Specifically, the example view 202A represents the depth and the length of the example IC 200A as annotated in FIG. 2A. The example view 202A may distort the relative distance between components for simplicity. Similarly, the example view 202A includes a limited number of layers and limited number of components for simplicity. In practice, the example IC 200A may include additional layers and/or additional components besides those illustrated in the example view 202A.

The example axes 203 describe a coordinate system that can be used to correlate the view 202A to the orientation of FIG. 2A. For example, the axes 203 includes an x axis that corresponds to the length of the IC 200A and is parallel to the text labels in FIG. 2A. Similarly, the axes 203 includes a z axis that corresponds to the depth of the IC 200A and is perpendicular to the text labels in FIG. 2A. As used previously and herein, the use of terms such as higher, above, elevated, etc., refer to positive z direction in FIG. 2A. For example, suppose a first component is elevated relative to a second component within the IC 200A. In such an example, the first component has a larger z value than the second component and is therefore positioned above the second component in the example view 202A. The vertical separation in the example view 202A visually indicates the first and second components are physically implemented at different depths in the example IC 200A.

The example wafer 204A is a base material that the example IC 200A is built upon. The example wafer 204A may include semiconductor materials such as silicon, germanium, etc. During fabrication, the example IC 200A may be manufactured by adding consecutive layers of material on top of the wafer 204A. In the illustrative example of FIG. 2A, however, the example IC 200A is attached to the example external circuitry 214A using a flip chip technique. In a flip chip method, the IC 200A is "flipped" so that the example power interconnects 212A have direct contact to the example external circuitry, which provides power to the IC 200A. As a result, the example wafer 204A is illustrated in the example view 202A above (i.e., having a greater +z value using the axes 203 than) the other components of the example IC 200A.

The example transistors 206A are two circuit elements in the transistor layer of the example IC 200A. The transistor layer may include any number of circuit elements. The transistor layer may also include any type of circuit elements, including but not limited to transistors, capacitors, resistors, inductors, etc. In general, the example transistors 206A are positioned at the same depth within the IC 200A (i.e., the same z value using axes 203) as the rest of the transistor layer.

The example signal interconnects 208A connect the circuit elements of the transistor layer to one another. Within the example signal interconnects 208A, the example signal interconnect 210A connects the transistors 206A to one another. In the illustrative example of FIG. 2A, the example signal interconnect 210A extends into the first of four layers that were fabricated above the transistor layer. The four layers are labelled in FIG. 2B as L1A, L2A, L3A, and L4A, respectively, with L1A being closest to the frontside of the wafer 204A. The four layers are illustrated below the transistor layer (i.e., a smaller z value using axes 203) in the example view 202A because the IC 200A was flipped.

The example power interconnects 212A provide power to the IC 200A. To provide power, the power interconnects 212A connect to the transistor layer on one end and to external circuitry 214A on the other end. In As a result, the power interconnects 212A extend through all four vertical layers.

The example external circuitry 214A refers to circuitry that is manufactured independently and separately from the example IC 200A. The example external circuitry 214A is connected electrically to the example IC 200A and may perform operations based on the functionality of the example IC 200A. To connect electrically, the example external circuitry 214A also connects physically to the IC 200A. The physical connection enables the external circuitry 214A to provide power through the power interconnects 212A and instructions through the signal interconnects 208A.

FIG. 2B is an illustrative example of an IC package manufactured using back side power delivery techniques. FIG. 2B includes the example signal sensor circuitry 114, an example IC 200B, an example view 202B, example axes 203, and example external circuitry 214. The example view 202B includes an example wafer 204B, example transistors 206B, example signal interconnects 208B, example signal interconnect 210B, and example power interconnects 212B.

The example IC 200B is an IC fabricated using the example system 100 and backside power delivery techniques. The example IC 200B is illustrated as a rectangular prism in FIG. 2B to visually indicate that the example IC 200B is a 3-dimensional object. The dimensions are labelled on the example IC 200B as length, width, and depth.

The example view 202B is a cross sectional view of the example IC 200B. The example view 202B visually illustrates two of the three dimensions of the example IC 200B. Specifically, the example view 202B represents the depth and the length of the example IC 200B as annotated in FIG. 2B. The example view 202B may distort the relative distance between components for simplicity. Similarly, the example view 202B includes a limited number of layers and limited number of components for simplicity. In practice, the example IC 200B may include additional layers and/or additional components besides those illustrated in the example view 202B.

Like FIG. 2A, the example axes 203 correlate the view 202B to the orientation of FIG. 2B. For example, suppose a first component is elevated relative to a second component within the IC 200B. In such an example, the first component has a larger z value than the second component and is therefore positioned above the second component in the example view 202B. The vertical separation in the example view 202B visually indicates the first and second components are physically implemented at different depths in the example IC 200B.

The example wafer 204B is a base material that the example IC 200B is built upon. The example wafer 204B may include semiconductor materials such as silicon, germanium, etc. During fabrication, the example IC 200B may be manufactured by adding consecutive layers for signal interconnects on top of the wafer 204A. Unlike FIG. 2A, the example IC 200B is not attached to the example external circuitry 214A using a flip chip technique. As a result, the example wafer 204A is illustrated in the example view 202A in a "front side up" configuration where the front side of the wafer 204B is above (i.e., has a greater z value using the axes 203 than) the backside of the wafer 204B.

The example transistors 206B are two circuit elements in the transistor layer of the example IC 200B. The transistor layer may include any number of circuit elements. The transistor layer may also include any type of circuit elements, including but not limited to transistors, capacitors, resistors, inductors, etc.

The example transistors 206B are the same type of transistors as the example transistors 206A. The example 206B are also example implementations of the transistors 110A, 110B of FIG. 1. In general, the example transistors 206B are positioned at the same depth within the IC 200B (i.e., the same z value using axes 203) as the rest of the transistor layer.

The example signal interconnects 208B connect the circuit elements of the transistor layer to one another. Within the example signal interconnects 208B, the example signal interconnect 210B connects the transistors 206B to one another. In the illustrative example of FIG. 2B, the example signal interconnect 210B extends into three of four vertical layers that were fabricated above the transistor layer. The four layers are labelled in FIG. 2B as L1B, L2B, L3B, and L4B, respectively, with L1B being closest to the frontside of the wafer 204B. The example signal interconnect 210B extends into layer L3B using a physical terminal. A physical terminal is not a circuit element that changes the logic or functionality of the example IC 200B. Rather, the physical terminal enables the voltage from the transistors 206B to extend closer to the example signal sensor circuitry 114. Physical terminals are discussed further in connection with FIG. 2B.

The example power interconnects 212B provide power to the IC 200A. To provide power, the power interconnects 212B electrically connect to the transistor layer on one end and to external circuitry 214B on the other end. In the backside power delivery technique, the power interconnects 212B maintain their connection to the external circuitry in the IC layers formed on the backside of the wafer 204B. In the illustrative example of FIG. 2B, the power interconnects 212B may connect to the transistor layer using one or more conducting vias that extends through the example wafer 204B. In other examples, the power interconnects 212B may connect to the transistor layer using a different technique. Within the example power interconnects 212B, the power interconnect 216B connects a power source from external circuitry to a physical terminal located in layer L3B.

The example external circuitry 214B refers to circuitry that is manufactured independently and separately from the example IC 200B. The example external circuitry 214B is connected electrically to the example IC 200B and may perform operations based on the functionality of the example IC 200B. To connect electrically, the example external circuitry 214B also connects physically to the IC 200B. The physical connection enables the external circuitry 214B to provide power through the power interconnects 212B and instructions through the signal interconnects 208B.

The example IC 200A and example IC 200B are logically equivalent in that they both implement the same circuit and, if there are no errors in the fabrication process, provide the same functionality. The example IC 200A is fabricated using front side power delivery. As a result, the signal interconnects 208A and power interconnects 212A are implemented in the same vertical layers on the front side of the wafer 204A.

The example IC 200B is fabricated using back side power delivery. As a result, the example signal interconnects 208B have more space in the IC layers formed on the front side of the wafer 204B than the signal interconnects 208A have space in the IC layers on the front side of the wafer 204A. This increased space may result in the example IC 200B exhibiting an improved performance relative to the IC 200A.

The example signal interconnect 210A and example signal interconnect 210B refer to the same signal within the shared circuitry logic of the example IC 200A, 200B. The example signal interconnect 210A and example signal interconnect 210B carry an important signal that requires measurement for proper debugging and verification of functionality. Similarly, the power interconnects 212A and power interconnects 212B carry the same reference voltages and require measurement for proper debugging and verification of functionality. In the example IC 200A, layer L1A is close enough that the signal interconnect 210A and the power interconnects 212A can be measured by the signal sensor circuitry 114.

If un-modified, original circuitry logic was used to determine the layout of the IC 200B, the signal interconnect 210B would natively extend into only L1B, as seen in the logically equivalent signal interconnect 21 0A. Advantageously, the modified circuitry logic generated by the example designer circuitry 104 instructs the fabricator 106 to elevate the signal interconnect into L3B. In the illustrative example of FIG. 2B, the example signal sensor circuitry 114 cannot accurately measure interconnects that stop within L1B due to the distance but can accurately measure interconnects within L3B. As a result, the example signal sensor circuitry 114 can measure the voltage of both the signal interconnect 210B and the power interconnect 216B. The example designer circuitry 104 further increases the viability of backside power delivery techniques by ensuring that identified power and signal voltages can be accurately measured for debugging and verification purposes.

FIG. 3 is a block diagram of the example designer circuitry 104 to create a circuit layout. The example designer circuitry 104 of FIG. 3 may be instantiated (e.g., creating an instance of, bring into being for any length of time, materialize, implement, etc.) by processor circuitry such as a central processing unit executing instructions. Additionally or alternatively, example designer circuitry 104 of FIG. 3 may be instantiated (e.g., creating an instance of, bring into being for any length of time, materialize, implement, etc.) by an ASIC or an FPGA structured to perform operations corresponding to the instructions. It should be understood that some or all of the circuitry of FIG. 3 may, thus, be instantiated at the same or different times. Some or all of the circuitry may be instantiated, for example, in one or more threads executing concurrently on hardware and/or in series on hardware. Moreover, in some examples, some or all of the circuitry of FIG. 3 may be implemented by microprocessor circuitry executing instructions to implement one or more virtual machines and/or containers. The example designer circuitry 104 includes example interface circuitry 302, example identifier circuitry 304, example port adder circuitry 306, example buffer circuitry 308, example connector circuitry 310, and example layout planner circuitry 312.

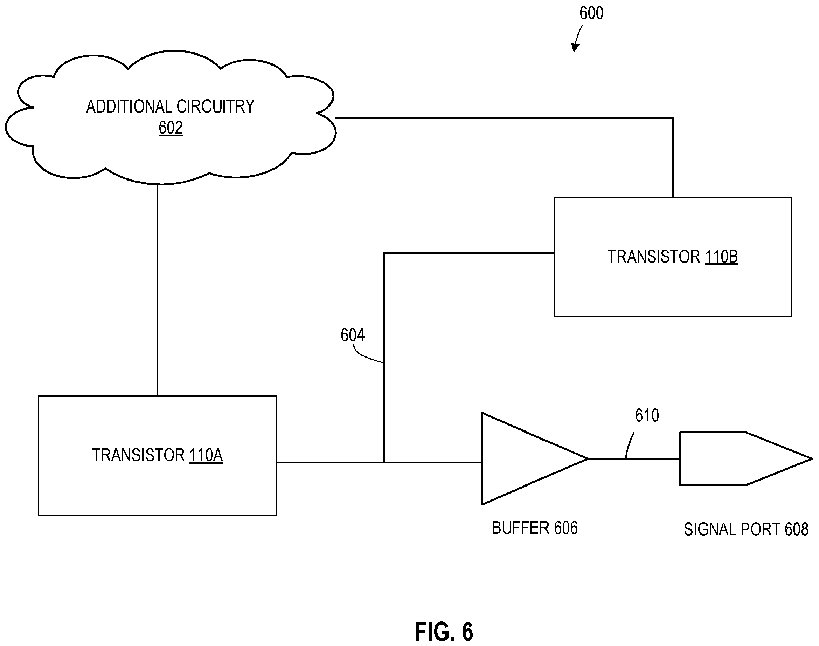

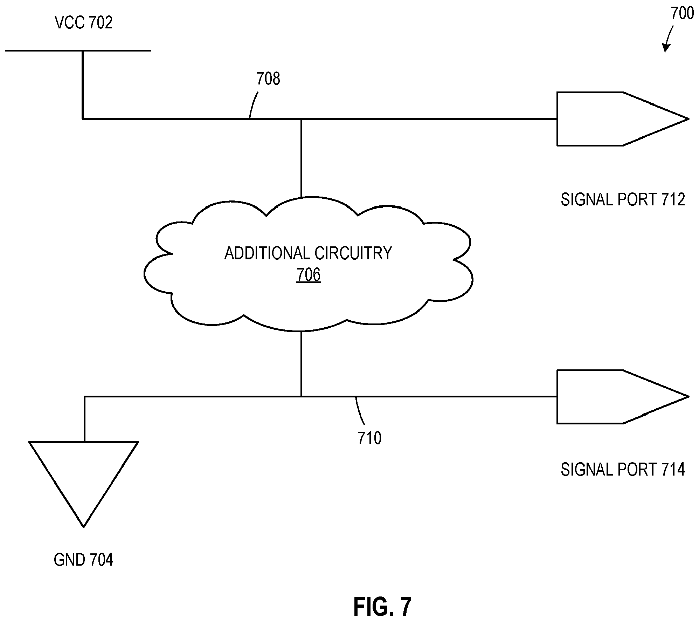

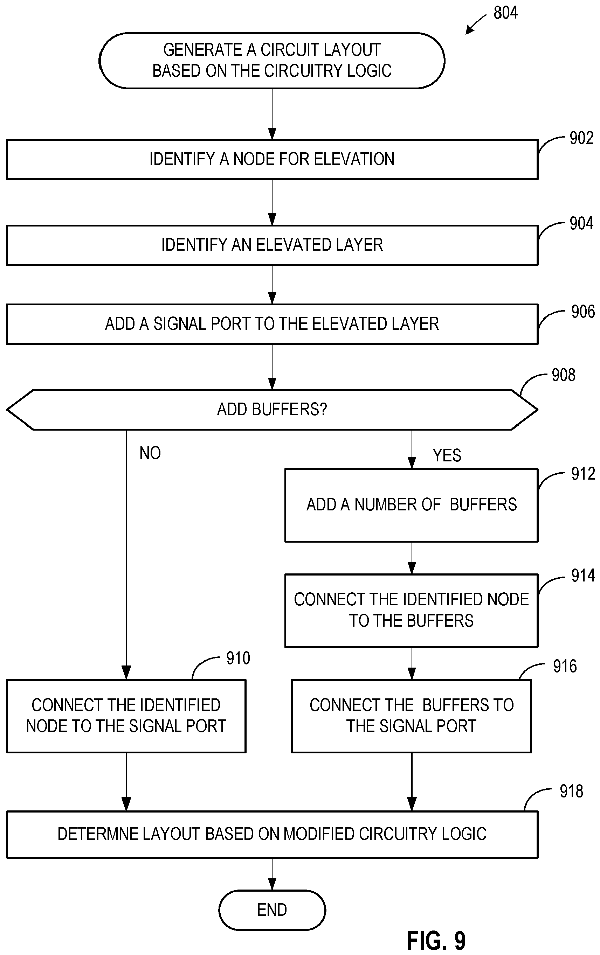

The example interface circuitry 302 obtains circuitry logic from the example programmer 102. The example interface circuitry 302 may implement any type of interface circuitry and communicate with any type of peripheral to obtain the circuitry logic from the programmer 102. For example, the designer circuitry 104 may implement a user interface that the programmer 102 views on a display. In some examples, the user interface is a visual representation of a netlist such as a circuit diagram. In other examples, the user interface is a test based description of the circuitry logic. In some examples, the programmer 102 may provide the circuitry logic by using a keyboard and/or mouse to interact with the user interface. User interfaces are discussed further in connection with FIGS. 6, 7. In some examples, the interface circuitry 302 is instantiated by processor circuitry executing interface instructions and/or configured to perform operations such as those represented by the flowchart of FIG. 9.

In some examples, the example designer circuitry 104 includes means for obtaining circuitry logic. For example, the means for obtaining may be implemented by interface circuitry 302. In some examples, the interface circuitry 302 may be instantiated by processor circuitry such as the example processor circuitry 1012 of FIG. 10. For instance, the interface circuitry 302 may be instantiated by the example microprocessor 1100 of FIG. 11 executing machine executable instructions such as those implemented by at least blocks 802 of FIG. 8. In some examples, the interface circuitry 302 may be instantiated by hardware logic circuitry, which may be implemented by an ASIC, XPU, or the FPGA circuitry 1200 of FIG. 12 structured to perform operations corresponding to the machine readable instructions. Additionally or alternatively, the interface circuitry 302 may be instantiated by any other combination of hardware, software, and/or firmware. For example, the interface circuitry 302 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) structured to execute some or all of the machine readable instructions and/or to perform some or all of the operations corresponding to the machine readable instructions without executing software or firmware, but other structures are likewise appropriate.

The example identifier circuitry 304 identifies a node for elevation within the circuitry logic provided by the programmer 102. The example identifier circuitry 304 may additionally or alternatively identify a node based on a pre-determined rule set. The pre-determined rule set may be set by a manufacturer and may be based on the type of functionality implemented by the IC. The example identifier circuitry 304 also identifies a layer within the fabricated IC corresponding to the identified node. The example identifier circuitry 304 may only identify a layer that is close enough to the signal sensor circuitry 114 for accurate detection and voltage measurement. The layer identified by the example identifier circuitry 304 may be based on factors such as the type of signal sensor circuitry 114, instructions from the programmer 102, etc.

In some examples, the identifier circuitry 304 may identify more than one node and more than one layer. In such examples, each identified node has a corresponding identified layer. Furthermore, two identified nodes may both correspond to the same identified layer. In some examples, the identifier circuitry 304 is instantiated by processor circuitry executing identifier instructions and/or configured to perform operations such as those represented by the flowchart of FIG. 9.

In some examples, the example designer circuitry 104 includes means for identifying. For example, the means for identifying may be implemented by identifier circuitry 304. In some examples, the identifier circuitry 304 may be instantiated by processor circuitry such as the example processor circuitry 1012 of FIG. 10. The identifier circuitry 304 may be instantiated by the example microprocessor 1100 of FIG. 11 executing machine executable instructions such as those implemented by at least blocks 902, 904 of FIG. 9. In some examples, the identifier circuitry 304 may be instantiated by hardware logic circuitry, which may be implemented by an ASIC, XPU, or the FPGA circuitry 1200 of FIG. 12 structured to perform operations corresponding to the machine readable instructions. Additionally or alternatively, the identifier circuitry 304 may be instantiated by any other combination of hardware, software, and/or firmware. For example, the identifier circuitry 304 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) structured to execute some or all of the machine readable instructions and/or to perform some or all of the operations corresponding to the machine readable instructions without executing software or firmware, but other structures are likewise appropriate.

The example port adder circuitry 306 modifies the circuitry logic by adding a signal port to each of the identified nodes. From a circuit design perspective, a signal port can be viewed as a circuit element that connects to another circuit element through a node. When the fabricator 106 receives the circuit layout, however, it implements the signal port as a physical terminal. A terminal refers to a point at which an electrical conductor ends. At a larger scale, a terminal may include but is not limited to a metal leg or a pin that connects an IC to external circuitry such as a motherboard. Within the layers of an IC, a terminal may be a region of conducting material (i.e., the interconnect) that is surrounded by a region of insulating materials.

The example port adder circuitry 306 adds the signal port to the layer identified by the identifier circuitry 304. The identified layer is elevated relative to the transistor layer of the IC. The example port adder circuitry 306 may add the signal port in the vicinity of one of the circuit elements that the signal will be routed to or from. That is, using FIG. 2B as an example, the example port adder circuitry 306 may add a signal port such that the corresponding physical terminal (e.g., the terminal in layer L3B at the end of signal interconnect 210B) is located close to its connected circuit elements (e.g., the transistors 206B) with respect to length and width (e.g., similar x and y values using axes 203), but is located farther away from the connected circuit elements with respect to depth (e.g., different z values using the axes 203). The precise distance in any of three dimensions between a physical terminal and the connected circuit elements may depend on the number of circuit elements in the transistor layer, the number of interconnects, the type of materials used to fabricate the IC, etc. In some examples, the port adder circuitry 306 is instantiated by processor circuitry executing port adder instructions and/or configured to perform operations such as those represented by the flowchart of FIG. 9.

In some examples, the example designer circuitry 104 includes means for adding a signal port. For example, the means for adding a signal port may be implemented by port adder circuitry 306. In some examples, the port adder circuitry 306 may be instantiated by processor circuitry such as the example processor circuitry 1012 of FIG. 10. For instance, the port adder circuitry 306 may be instantiated by the example microprocessor 1100 of FIG. 11 executing machine executable instructions such as those implemented by at least blocks 906 of FIG. 9. In some examples, the port adder circuitry 306 may be instantiated by hardware logic circuitry, which may be implemented by an ASIC, XPU, or the FPGA circuitry 1200 of FIG. 12 structured to perform operations corresponding to the machine readable instructions. Additionally or alternatively, the port adder circuitry 306 may be instantiated by any other combination of hardware, software, and/or firmware. For example, the port adder circuitry 306 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) structured to execute some or all of the machine readable instructions and/or to perform some or all of the operations corresponding to the machine readable instructions without executing software or firmware, but other structures are likewise appropriate.

The example buffer circuitry 308 obtains the circuitry logic from the port adder circuitry 306. The buffer circuitry 308 determines whether to further modify the circuitry logic by adding buffers between the identified node and the physical terminal. Buffers refer to circuit elements that are designed to electrically isolate nodes from one another. Buffers do not influence the desired functionality of a circuit, but instead provide value by preventing a signal source on one end of an interconnect from being impacted by unknown currents or voltages that may affect a load on the other side of the interconnect. A buffer may be implemented by circuit elements such as a unity gain amplifier. While electrical isolation between nodes is generally desirable, buffers do require additional space within the IC to implement. Buffers may also increase the cost of fabricating an IC. Therefore, an example programmer 102 or an IC manufacturer may or may not choose to add buffers between the identified node and the physical terminal based on factors such as budget, the electrical properties of the circuit elements on either side of the interconnect, the importance of the voltage in the interconnect for debugging and verification purposes, etc.

The example buffer circuitry 308 may determine whether to add buffers based on instructions from the programmer 102 and/or according to a pre-determined rule set. For example, a pre-determined rule set may instruct the example buffer circuitry 308 to add buffers to any interconnect that provides a supply voltage. Additionally or alternatively, a pre-determined rule set may instruct the example buffer circuitry 308 to add buffers to any interconnect that connects a first type of circuit element to a second type of circuit element. A pre-determined rule set may be set by an IC manufacturer and may cause the buffer circuitry 308 to add buffers to any quantity or type of interconnects.

If the example buffer circuitry 308 decides to add buffers, the example buffer circuitry 308 further determines how many buffers should be added. In some examples, using more than one buffer can help electrically isolate multiple loads on a node from one another. If multiple buffers are added to a single node, the example buffer circuitry 308 may connect the buffers to one another in series. The example buffer circuitry 308 also connects the identified node to one of the buffers. Alternatively, if the example buffer circuitry 308 decides not to add buffers, the example buffer circuitry 308 may provide the circuitry logic to the example connector circuitry 310 without further modifications. In some examples, the buffer circuitry 308 is instantiated by processor circuitry executing buffer elevator instructions and/or configured to perform operations such as those represented by the flowchart of FIG. 9.

In some examples, the example designer circuitry 104 includes means for buffering. For example, the means for buffering may be implemented by buffer circuitry 308. In some examples, the buffer circuitry 308 may be instantiated by processor circuitry such as the example processor circuitry 1012 of FIG. 10. For instance, the buffer circuitry 308 may be instantiated by the example microprocessor 1100 of FIG. 11 executing machine executable instructions such as those implemented by at least blocks 912 - 916 of FIG. 9. In some examples, the buffer circuitry 308 may be instantiated by hardware logic circuitry, which may be implemented by an ASIC, XPU, or the FPGA circuitry 1200 of FIG. 12 structured to perform operations corresponding to the machine readable instructions. Additionally or alternatively, the buffer circuitry 308 may be instantiated by any other combination of hardware, software, and/or firmware. For example, the buffer circuitry 308 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) structured to execute some or all of the machine readable instructions and/or to perform some or all of the operations corresponding to the machine readable instructions without executing software or firmware, but other structures are likewise appropriate.

The example connector circuitry 310 modifies the circuitry logic by connecting the signal port from the port adder circuitry 306 to the identified node. When the example connector circuitry 310 receives the circuitry logic from the buffer circuitry 308, the modified circuitry logic may or may not include buffers. If the modified circuitry logic contains buffers, the example connector circuitry 310 connects the signal port to the closest buffer. Because the one or more buffers connect to one another, and at least one of the buffers has a direct connection to the identified node, the signal port is indirectly connected to the identified node in the modified circuitry logic. If the modified circuitry logic does not contain buffers, the example connector circuitry 310 connects directly to the identified node. As a result, the signal port, the identified node, and any intermediate buffers are connected to one another and share the same electrical properties (e.g., experience the same voltage). In some examples, the connector circuitry 310 is instantiated by processor circuitry executing connector instructions and/or configured to perform operations such as those represented by the flowchart of FIG. 9.

In some examples, the example designer circuitry 104 includes means for connecting, in circuitry logic, a signal port to the identified node. For example, the means for connecting may be implemented by the connector circuitry 310. In some examples, the connector circuitry 310may be instantiated by processor circuitry such as the example processor circuitry 1012 of FIG. 10. For instance, the connector circuitry 310may be instantiated by the example microprocessor 1100 of FIG. 11 executing machine executable instructions such as those implemented by at least blocks 910, 916 of FIG. 9. In some examples, the connector circuitry 310 may be instantiated by hardware logic circuitry, which may be implemented by an ASIC, XPU, or the FPGA circuitry 1200 of FIG. 12 structured to perform operations corresponding to the machine readable instructions. Additionally or alternatively, the connector circuitry 310 may be instantiated by any other combination of hardware, software, and/or firmware. For example, the connector circuitry 310 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) structured to execute some or all of the machine readable instructions and/or to perform some or all of the operations corresponding to the machine readable instructions without executing software or firmware, but other structures are likewise appropriate.

The example layout planner circuitry 312 determines the layout of the physical IC based on the modified circuitry logic. For example, the layout planner circuitry 312 may determine the position of the circuit elements within the transistor layer, the position of the power interconnects, and the position of signal interconnects within the fabricated IC. Determining the layout of the physical IC may also be referred to as place and route. In some examples, the example layout planner circuitry 312 may execute a place and route software application to determine the layout of an IC. In such examples, the port adder circuitry 306, buffer circuitry 308, and connector circuitry 310 may implement their respective circuit modifications by amending files or similarly providing computer readable instructions that are compatible with the specific place and route software application executed by the example layout planner circuitry 312. Examples of place and route software applications that may be executed by the example layout planner circuitry 312 include but are not limited to the Innovus Implementation System developed by Cadence^{®} and auto-place-and-route (APR) electronic design automation (EDA) software within the Synopsys^{®} Fusion Compiler^{™}. The example layout planner circuitry 312 provides the layout to the example fabricator 106. In some examples, the layout planner circuitry 312 is instantiated by processor circuitry executing layout planner instructions and/or configured to perform operations such as those represented by the flowchart of FIG. 9.

In some examples, the example designer circuitry 104 includes means for determining a layout of the integrated circuit. For example, the means for determining may be implemented by layout planner circuitry 312. In some examples, the layout planner circuitry 312 may be instantiated by processor circuitry such as the example processor circuitry 1012 of FIG. 10. For instance, the layout planner circuitry 312may be instantiated by the example microprocessor 1100 of FIG. 11 executing machine executable instructions such as those implemented by at least blocks 918 of FIG. 9. In some examples, the layout planner circuitry 312 may be instantiated by hardware logic circuitry, which may be implemented by an ASIC, XPU, or the FPGA circuitry 1200 of FIG. 12 structured to perform operations corresponding to the machine readable instructions. Additionally or alternatively, the layout planner circuitry 312 may be instantiated by any other combination of hardware, software, and/or firmware. For example, the layout planner circuitry 312 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) structured to execute some or all of the machine readable instructions and/or to perform some or all of the operations corresponding to the machine readable instructions without executing software or firmware, but other structures are likewise appropriate.

When performing place and route functionality, the example layout planner circuitry 312 may natively place some interconnects in layers that are close enough for the signal sensor circuitry 114 to observe. However, if the original circuitry logic provided by the programmer 102, there is no way to ensure that a specific signal deemed important for debugging and verification will be in a high enough layer to be accurately measured. Furthermore, using the original circuitry logic, layers of signal interconnects that are sufficiently close to the signal sensor circuitry 114 for measurement may be natively less dense than interconnect layers that are closer to the circuit elements and the wafer.

The example designer circuitry 104 modifies the circuitry logic by adding a physical terminal to a layer of an IC and connecting the terminal to an identified node. Advantageously, the modified circuity logic causes the layout planner circuitry 312 to place a physical terminal within a layer that is close enough to the example signal sensor circuitry 114 for accurate detection and voltage measurement. As a result, when the example fabricator 106 produces the IC package 108, any critical signal identified by the example programmer 102 or IC manufacturer can be measured for debugging and verification purposes, even when the IC package 108 is fabricated using back power delivery techniques.

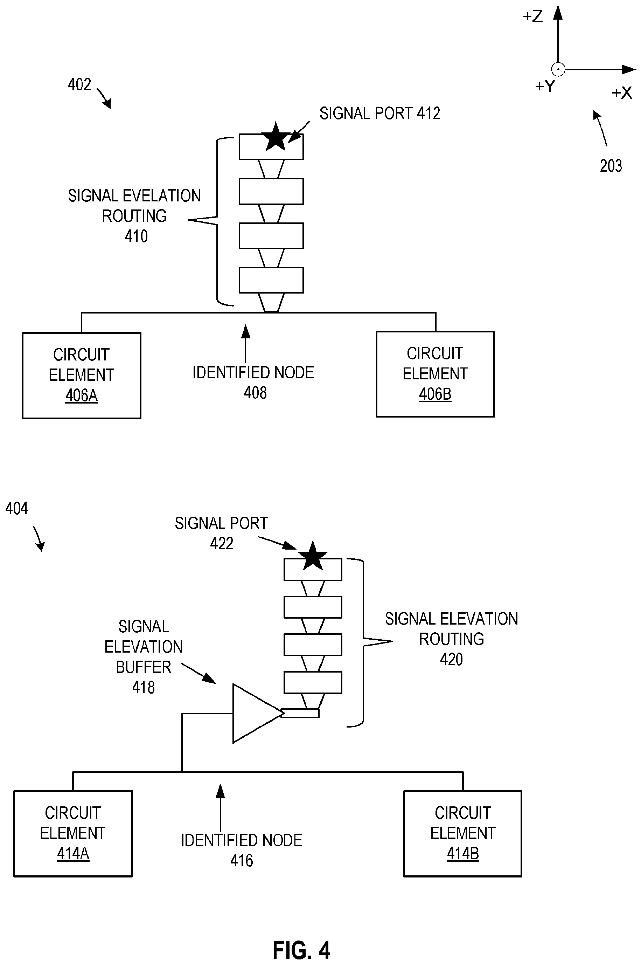

FIG. 4 is a first illustrative example of the buffer circuitry of FIG. 3. FIG. 4 includes an example direction connection diagram 402 and an example buffered connection diagram 404. The example direct connection diagram 402 includes example circuit elements 406A, 406B, an example identified node 408, example signal elevation routing 410, and an example signal port 412. The example buffered connection diagram 404 includes example circuit elements 414A, 414B, an example identified node 416, an example buffer 418, example signal elevation routing 420, and an example signal port 422.

The example direct connection diagram 402 and the example buffered connection diagram 404 both represent cross sectional views of ICs that were fabricated using modified circuitry logic provided by the example designer circuitry 104. Specifically, the example direct connection diagram 402 and example buffered connection diagram 404 are oriented in relation to the example axes 203. As a result, a first component illustrated above a second component illustrate indicates that the two components have different z values and are implemented at different depths within the IC. The example direct connection diagram 402 and example buffered connection diagram 404 are not illustrated to scale, for simplicity. In practice, an example IC may include additional layers and/or additional circuit elements besides those illustrated in the example direct connection diagram 402 and example buffered connection diagram 404.

The example circuit elements 406A, 406B are two of a plurality of circuit elements in the transistor layer of the example IC package 108. The example circuit elements 406A, 406B may be any type of circuit element, including but not limited to transistors, resistors, capacitors, inductors, etc. Within the original circuitry logic provided by the programmer 102, example circuit elements 406A, 406B are connected to one another by the example identified node 408.

Without modification to the circuitry logic by the example designer circuitry 104, the example fabricator circuitry may implement the identified node 408 in a set of layers that are not observable by the example signal sensor circuitry 114. As a result, the example designer circuitry 104 modifies the circuitry logic to add the signal elevation routing 410 and signal port 412. The example signal elevation routing 410 is implemented by an interconnect that spans across one or more layers of the IC package 108. The interconnect connects the identified node 408 and a physical terminal corresponding to the signal port 412. In turn, the example signal sensor circuitry 114 can detect a voltage at the physical terminal corresponding to the signal port 412 for the identified node 408 due to the modified circuitry logic in the example designer circuitry 104.

Like the example direct connection diagram 402, the example buffered connection diagram 404 represents an IC that is implemented with an interconnect in an elevated layer to ensure that example signal sensor circuitry 114 can detect and measure an identified node. The example buffered connection diagram also includes an example buffer 418 between the example identified node 416 and the example signal elevation routing 420.

As the amount of metal in an interconnect increases, the power consumed by the interconnect increases due to the added resistance of extra metal. In the example direct connection diagram 402, the identified node 408 and the signal elevation routing 410 are part of the same physical interconnect. As a result, the performance and timing characteristics of the identified node 408 are impacted by the extra metal from the signal elevation routing 410 consuming additional power.

In contrast, the example buffer 418 forms two separate interconnects. The first interconnect implements the identified node 416 and connects the circuit elements 416A, 416B to each other and to the buffer 418. The second interconnect implements the signal elevation routing 420 and connects the buffer 418 to a physical terminal corresponding to the signal port 422. The first interconnect and second interconnect may carry the same signal, but the buffer 418 ensures that the performance and timing characteristics of the first interconnect are not impacted by that the second interconnect. The example designer circuitry 104 supports signal elevation both with and without the addition of buffers so that the example programmer 102 can choose a design based on budget, die size, and performance considerations.

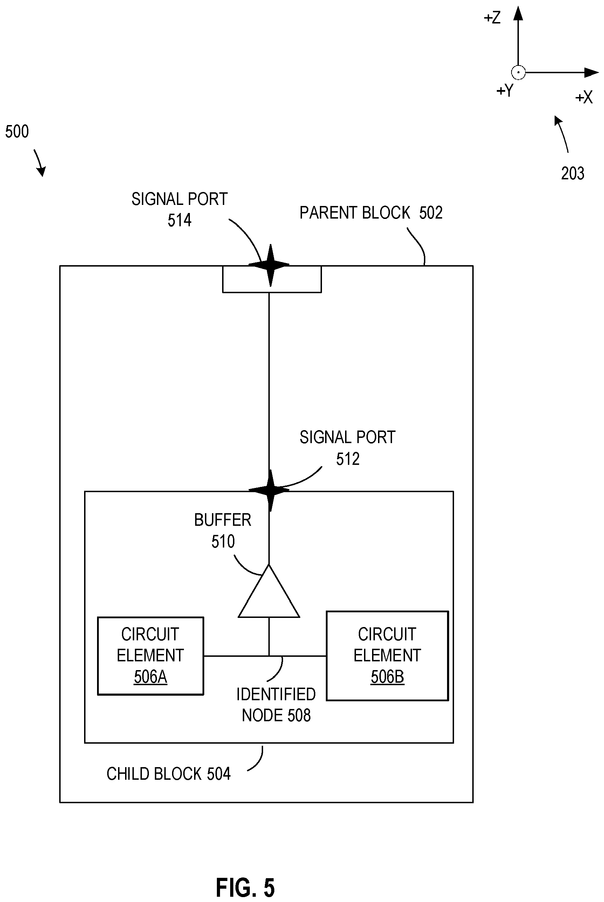

FIG. 5 is a second illustrative example of the buffer elevator circuitry of FIG. 3. FIG. 5 includes an example sub-block diagram 500. The example sub-block diagram 500 includes a parent block 502 and a child block 504. The child block 504 includes example circuit elements 506A, 506B, an example identified node 508, an example buffer 510, and example signal port 512. The example parent block 502 includes the example signal port 514.

The example sub-block diagram 500 represents a cross sectional view of an IC that was fabricated using modified circuitry logic provided by the example designer circuitry 104. Specifically, the example sub-block diagram 500 are oriented in relation to the example axes 203. As a result, a first component illustrated above a second component illustrate indicates that the two components have different z values and are implemented at different depths within the IC. The example sub-block diagram 500 is not illustrated to scale, for simplicity. In practice, an example IC may include additional layers and/or additional circuit elements besides those illustrated in the example direct connection diagram 402 and example sub-block diagram 500.

The example sub-block diagram 500 represents an IC that has a child block 504 and a parent block 502. A child block 504 represents a set of circuit elements and interconnects that are designed independently of the parent block 502 and the rest of the IC. Given a set of standardized inputs, the example child block 504 may be able to achieve a desired functionality without additional relying on additional resources from external circuitry. As a result, the design of the example child block 504 may be implemented within different types of ICs, including within the example parent block 502. In some examples, the child block 504 may be referred to as an Intellectual Property (IP) core. In some examples, the child block 504 may be referred to as a child circuit. Similarly, in some examples, the parent block 502 may be referred to as a parent circuit.

In the illustrative example of FIG. 5, the example child block 504 is implemented using only a subset of interconnect layers that are closest to the transistor layer. Additional interconnect layers that implement parent block 502 functionality are implemented on top of the child block 504. In previous solutions, the intermediate layers of parent block functionality may make the example identified node 408 unobservable to the example signal sensor circuitry 114.

The example designer circuitry 104 elevates the identified node 408 for observability by adding the signal ports 512, 514. Without the example signal port 512, place and route software applications would keep the region of the parent block 502 and the child block 504 electrically and physically isolated from one another to avoid interfering with the stand-alone functionality of the child block 504. By modifying the circuitry logic with the inclusion and connection of the example signal port 512, the example port adder circuitry 306 and example connector circuitry 310 instruct the example layout planner circuitry 312 to implement a physical terminal that is 1) located at the boundary of the child and parent block regions and 2) connected to the identified node 408. Additionally, the inclusion and connection of the signal port 514 extends the signal from the identified node 408 to an elevated layer where it can be detected and measured by the example signal sensor circuitry 114.

The buffer circuitry 308 may add a buffer to a child block 504, either by instruction from the programmer 102 or according to a pre-determined rule set, to protect the intended functionality of the child block 504. For example, the child block 504 may be designed and implemented with an expected size and expected power consumption of the interconnect that implements the identified node 508. By adding the buffer 510, the interconnect that connects the signal port 512 to the signal port 514 is electrically isolated from the interconnect that implements the identified node 508. Therefore, the added load of the interconnect that extends through the parent block 502 does not affect the expected size and expected power consumption of the interconnect in the child block 504. The buffer 510 is additionally advantageous because it ensures the child block 504 is compatible with a variety of parent blocks that may implement interconnects of various sizes and power consumptions.

FIG. 6 is a first illustrative example of a circuit diagram. The example circuit diagram 600 includes example transistors 110A, 110B, example additional circuitry 602, an example node 604, an example buffer 606, an example signal port 608, and an example node 610.

The example circuit diagram 600 is a visual representation of the modified circuity logic used by the layout planner circuitry 312. That is, the example circuit diagram 600 describes the number of circuit elements in the circuit, the type of circuit elements, and the nodes that connect the circuit elements. The position of circuit elements within the example circuit diagram 600, however, does not correspond to the position of the circuit elements when physically implemented by the fabricator 106. The example circuit diagram 600 is one example of a visual representation that may be presented on a user interface via the interface circuitry 302.

In the illustrative example of FIG. 6, the example programmer 102 provided original circuitry logic. The original circuitry logic includes the example transistors 110A, 11 0B, and the example node 604 to connect the transistors. The original circuitry logic also includes additional circuitry 602 that connects to the example transistors 110A, 110B. The additional circuitry 602 may refer to any number of additional circuit elements connected by any number of additional nodes. In the illustrative example of FIG. 6, only the node 604 was identified as important for debugging and verification purposes. In other examples, more than one node may be identified by the example programmer 102.

To ensure the node 604 is observable to the example signal sensor circuitry 114 for debugging, the example port adder circuitry 306 adds the signal port 608 to the circuit diagram 600. In the illustrative example of FIG. 6, the example buffer circuitry 308 adds the buffer 606 to the circuit diagram 600 and connects the buffer 606 to node 604. In turn, the example connector circuitry 310 connects the buffer 606 to the signal port 608 using node 610. As a result, the signal port 608 is electrically connected to the node 604. When determining a layout for the IC, the example layout planner circuitry 312 will place a physical terminal corresponding to the signal port 608 in a layer of the IC that is elevated relative to the layer containing the examples transistors 110A, 110B. Therefore, the example node 604 will be observable to the example signal sensor circuitry 114 for debugging and verification purposes.

FIG. 7 is a second illustrative example of a circuit diagram. The example circuit diagram 700 includes an example Voltage Common Collector (VCC) element 702, example ground (GND) element 704, example additional circuitry 706, example nodes 708, 710, and example signal ports 712, 714.

The example circuit diagram 700 is a visual representation of the modified circuity logic used by the layout planner circuitry 312. That is, the example circuit diagram 700 describes the number of circuit elements in the circuit, the type of circuit elements, and the nodes that connect the circuit elements. The position of circuit elements within the example circuit diagram 700, however, does not correspond to the position of the circuit elements when physically implemented by the fabricator 106. The example circuit diagram 700 is one example of a visual representation that may be presented on a user interface via the interface circuitry 302.

The example VCC element 702 and example ground element 704 are elements of the power delivery network for the example circuit diagram 700. Specifically, the VCC element 702 provides a supply voltage used by one or more transistors in the additional circuitry 706. The example ground element provides a reference voltage and return path for electric current that flows through the circuit diagram 700. When determining the layout of the example IC package 108, the example layout planner circuitry 312 may implement a pin, metal leg, or other form of terminal so that for each of the VCC element 702 and ground element 704. The terminals allow the IC package 108 to obtain VCC and ground voltages from external circuitry and distribute the voltages to the other circuit elements via node 708 and node 710 respectively.

In the illustrative example of FIG. 7, the example programmer 102 provided original circuitry logic. The original circuitry logic includes the example VCC element 702, the example ground element 704, and additional circuitry 706. The additional circuitry 706 may refer to any number of additional circuit elements connected by any number of nodes. The original circuitry logic also includes node 708 to connect the VCC element 702 to one or more circuit elements within the additional circuitry 706 and node 710 to connect the ground element 704 to one or more circuit elements within the additional circuitry 706. In the illustrative example of FIG. 7, both node 708 and node 710 were identified as important for debugging and verification purposes.

To ensure nodes 708, 710 are both observable to the example signal sensor circuitry 114, the example port adder circuitry 306 adds the example signal ports 712, 714 to the circuit diagram 700. The example connector circuitry 310 connects the signal port 712 directly to node 708 and the signal port 714 directly to node 710. When determining a layout for the IC, the example layout planner circuitry 312 will place two physical terminals corresponding to the signal ports 712, 714. The physical terminals are placed in one or more layers of the IC that are elevated relative to the transistor layer. Therefore, the example nodes 708, 710 will be observable to the example signal sensor circuitry 114 for debugging and verification purposes.

In examples where power and ground nodes are measured, the example programmer 102 may wish to know the electrical characteristics of the interconnect that directly connect to the circuit elements at the transistor layer. Because a buffer implements a node as two separate interconnects, the example buffer circuitry 308 may receive instructions or otherwise determine not to add buffers to the example circuit diagram 700.

While an example manner of implementing the designer circuitry 104 of FIG. 1 is illustrated in FIG. 3, one or more of the elements, processes, and/or devices illustrated in FIG. 3 may be combined, divided, re-arranged, omitted, eliminated, and/or implemented in any other way. Further, the example interface circuitry 302, the identifier circuitry 304, the port adder circuitry 306, the buffer circuitry 308, the connector circuitry 310, the layout planner circuitry 312, and/or, more generally, the example designer circuitry 104 of FIG. 1, may be implemented by hardware alone or by hardware in combination with software and/or firmware. Thus, for example, any of the example interface circuitry 302, the identifier circuitry 304, the port adder circuitry 306, the buffer circuitry 308, the connector circuitry 310, the layout planner circuitry 312, and/or, more generally, the example designer circuitry 104 of FIG. 1, could be implemented by processor circuitry, analog circuit(s), digital circuit(s), logic circuit(s), programmable processor(s), programmable microcontroller(s), graphics processing unit(s) (GPU(s)), digital signal processor(s) (DSP(s)), application specific integrated circuit(s) (ASIC(s)), programmable logic device(s) (PLD(s)), and/or field programmable logic device(s) (FPLD(s)) such as Field Programmable Gate Arrays (FPGAs). Further still, the example designer circuitry 104 of FIG. 1 may include one or more elements, processes, and/or devices in addition to, or instead of, those illustrated in FIG. 3, and/or may include more than one of any or all of the illustrated elements, processes and devices.

A flowchart representative of example machine readable instructions, which may be executed to configure processor circuitry to implement the system 100 of FIG. 1, is shown in FIG. 8. A flowchart representative of example machine readable instructions, which may be executed to configure processor circuitry to implement the designer circuitry 104 of FIG. 3, is shown in FIG. 9. The machine readable instructions may be one or more executable programs or portion(s) of an executable program for execution by processor circuitry, such as the processor circuitry 1012 shown in the example processor platform 1000 discussed below in connection with FIG. 10 and/or the example processor circuitry discussed below in connection with FIGS. 10 and/or 11. The program may be embodied in software stored on one or more non-transitory computer readable storage media such as a compact disk (CD), a floppy disk, a hard disk drive (HDD), a solid-state drive (SSD), a digital versatile disk (DVD), a Blu-ray disk, a volatile memory (e.g., Random Access Memory (RAM) of any type, etc.), or a non-volatile memory (e.g., electrically erasable programmable read-only memory (EEPROM), FLASH memory, an HDD, an SSD, etc.) associated with processor circuitry located in one or more hardware devices, but the entire program and/or parts thereof could alternatively be executed by one or more hardware devices other than the processor circuitry and/or embodied in firmware or dedicated hardware. The machine readable instructions may be distributed across multiple hardware devices and/or executed by two or more hardware devices (e.g., a server and a client hardware device). For example, the client hardware device may be implemented by an endpoint client hardware device (e.g., a hardware device associated with a user) or an intermediate client hardware device (e.g., a radio access network (RAN)) gateway that may facilitate communication between a server and an endpoint client hardware device). Similarly, the non-transitory computer readable storage media may include one or more mediums located in one or more hardware devices. Further, although the example program is described with reference to the flowchart illustrated in FIGS. 8, 9, many other methods of implementing the example designer circuitry 104 may alternatively be used. For example, the order of execution of the blocks may be changed, and/or some of the blocks described may be changed, eliminated, or combined. Additionally or alternatively, any or all of the blocks may be implemented by one or more hardware circuits (e.g., processor circuitry, discrete and/or integrated analog and/or digital circuitry, an FPGA, an ASIC, a comparator, an operational-amplifier (op-amp), a logic circuit, etc.) structured to perform the corresponding operation without executing software or firmware. The processor circuitry may be distributed in different network locations and/or local to one or more hardware devices (e.g., a single-core processor (e.g., a single core central processor unit (CPU)), a multi-core processor (e.g., a multi-core CPU, an XPU, etc.) in a single machine, multiple processors distributed across multiple servers of a server rack, multiple processors distributed across one or more server racks, a CPU and/or a FPGA located in the same package (e.g., the same integrated circuit (IC) package or in two or more separate housings, etc.).

The machine readable instructions described herein may be stored in one or more of a compressed format, an encrypted format, a fragmented format, a compiled format, an executable format, a packaged format, etc. Machine readable instructions as described herein may be stored as data or a data structure (e.g., as portions of instructions, code, representations of code, etc.) that may be utilized to create, manufacture, and/or produce machine executable instructions. For example, the machine readable instructions may be fragmented and stored on one or more storage devices and/or computing devices (e.g., servers) located at the same or different locations of a network or collection of networks (e.g., in the cloud, in edge devices, etc.). The machine readable instructions may require one or more of installation, modification, adaptation, updating, combining, supplementing, configuring, decryption, decompression, unpacking, distribution, reassignment, compilation, etc., in order to make them directly readable, interpretable, and/or executable by a computing device and/or other machine. For example, the machine readable instructions may be stored in multiple parts, which are individually compressed, encrypted, and/or stored on separate computing devices, wherein the parts when decrypted, decompressed, and/or combined form a set of machine executable instructions that implement one or more operations that may together form a program such as that described herein.

In another example, the machine readable instructions may be stored in a state in which they may be read by processor circuitry, but require addition of a library (e.g., a dynamic link library (DLL)), a software development kit (SDK), an application programming interface (API), etc., in order to execute the machine readable instructions on a particular computing device or other device. In another example, the machine readable instructions may need to be configured (e.g., settings stored, data input, network addresses recorded, etc.) before the machine readable instructions and/or the corresponding program(s) can be executed in whole or in part. Thus, machine readable media, as used herein, may include machine readable instructions and/or program(s) regardless of the particular format or state of the machine readable instructions and/or program(s) when stored or otherwise at rest or in transit.

The machine readable instructions described herein can be represented by any past, present, or future instruction language, scripting language, programming language, etc. For example, the machine readable instructions may be represented using any of the following languages: C, C++, Java, C#, Perl, Python, JavaScript, HyperText Markup Language (HTML), Structured Query Language (SQL), Swift, etc.

As mentioned above, the example operations of FIGS. 8, 9 may be implemented using executable instructions (e.g., computer and/or machine readable instructions) stored on one or more non-transitory computer and/or machine readable media such as optical storage devices, magnetic storage devices, an HDD, a flash memory, a read-only memory (ROM), a CD, a DVD, a cache, a RAM of any type, a register, and/or any other storage device or storage disk in which information is stored for any duration (e.g., for extended time periods, permanently, for brief instances, for temporarily buffering, and/or for caching of the information). As used herein, the terms non-transitory computer readable medium, non-transitory computer readable storage medium, non-transitory machine readable medium, and non-transitory machine readable storage medium are expressly defined to include any type of computer readable storage device and/or storage disk and to exclude propagating signals and to exclude transmission media. As used herein, the terms "computer readable storage device" and "machine readable storage device" are defined to include any physical (mechanical and/or electrical) structure to store information, but to exclude propagating signals and to exclude transmission media. Examples of computer readable storage devices and machine readable storage devices include random access memory of any type, read only memory of any type, solid state memory, flash memory, optical discs, magnetic disks, disk drives, and/or redundant array of independent disks (RAID) systems. As used herein, the term "device" refers to physical structure such as mechanical and/or electrical equipment, hardware, and/or circuitry that may or may not be configured by computer readable instructions, machine readable instructions, etc., and/or manufactured to execute computer readable instructions, machine readable instructions, etc.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities and/or steps, the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities and/or steps, the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements or method actions may be implemented by, e.g., the same entity or object. Additionally, although individual features may be included in different examples or claims, these may possibly be combined, and the inclusion in different examples or claims does not imply that a combination of features is not feasible and/or advantageous.

FIG. 8 is flowchart representative of example machine readable instructions and/or example operations 800 that may be executed by example processor circuitry to implement the IC development system of FIG. 1. The example machine readable instructions and/or operations begin when the example designer circuitry 104 obtains original circuitry logic. (Block 802). In some examples, the interface circuitry 302 within the example designer circuitry 104 may obtain the original circuitry logic from the example programmer 102. In other examples, the interface circuitry 302 may obtain the original circuitry logic from an external device such as a server maintained by an IC manufacturer.

The example designer circuitry 104 generates a circuit layout based on the circuitry logic. (Block 804). The circuit layout includes a plurality of interconnects at various layers stacked above the circuit elements on the front side of the wafer. The example designer circuitry 104 modifies the circuitry layout such that specific nodes are implemented in specific layers of the IC. Block 804 is discussed further in connection with FIG. 9.

The example fabricator 106 fabricates the IC package 108 based on the circuitry logic. (Block 806). The example IC package 108 is a physical implementation of the circuit layout of block 804. The example fabricator 106 may use any number of fabrication techniques to fabricate the IC package 108. In the example flowchart of FIG. 8, the example fabricator 106 uses backside power delivery to implement power dedicated interconnects on the back side of the wafer.

The example signal sensor circuitry 114 determines voltages from elevated layers of the IC package 108. (Block 808). As illustrated in FIG. 2B, the example signal sensor circuitry 114 faces the layers of material that are stacked on the front side of the wafer. The example signal sensor circuitry 114 can only accurately detect and measure voltages in the first n layers of IC material that are closest to the sensor. Advantageously, the example designer circuitry 104 modifies the circuitry logic at block 804 such that nodes identified by the example programmer 102 are implemented within the first n layers of IC material closest to the sensor and are thus available for debugging or verification purposes.

FIG. 9 is a flowchart representative of the example machine readable instructions and/or example operations 800 that may be executed and/or instantiated by processor circuitry to generate a circuit layout. Specifically, flowchart described FIG. 9 describes how the example machine readable instructions and/or operations 800 implement block 804. In block 804, FIG. 9 describes the elevation of a single node to an IC layer that is closer to the signal sensor circuitry 114 than the transistor layer. In practice, the example designer circuitry 104 may implement blocks 902 - 916 multiple times to elevate multiple nodes. In some examples, the example designer circuitry 104 may execute one or more iterations of blocks 902 - 916 in parallel.

The example identifier circuitry 304 identifies a node within the original circuitry logic for elevation. (Block 902). The example identifier circuitry 304 may identify the node based on instructions provided with the original circuitry logic. Alternatively, the example identifier circuitry 304 may identify a node based on a pre-determined rule set.

The example identifier circuitry 304 identifies an elevated layer. (Block 904). The elevated layer refers to a specific layer of the IC package 108. The elevated layer contains interconnects that connect circuit elements to one another in the transistor layer. Because the fabricator 106 uses backside power delivery techniques to fabricate the example IC package 108, the distance between the elevated layer and the signal sensor circuitry 114 is smaller than the distance between the transistor layer and the signal sensor circuitry 114.

The example port adder circuitry 306 modifies the circuitry logic by adding a signal port to the elevated layer. (Block 906). The signal port is a circuit element that does not modify the functionality of the original circuitry logic. Rather, the circuit element is a data structure that causes the example layout planner circuitry 312 to insert a physical terminal in a specific layer of the example IC package 108.

The example buffer circuitry 308 determines whether to add buffers. (Block 908). In some examples, the buffer circuitry 308 may make the determination of block 908 based on instructions from the programmer 102. In other examples, the buffer circuitry 308 may determine whether to add buffers based on a pre-determined rule set.

If the example buffer circuitry 308 decides not to add buffers (Block 908: No), the example connector circuitry 310 modifies the circuitry logic by connecting the identified node directly to the signal port. (Block 910). Such a connection may be implemented as a single, continuous interconnect between two circuit elements and the signal port. The example machine readable instructions and/or operations 800 proceed to block 918 after block 910.

If the example buffer circuitry 308 decides to add buffers (Block 908: Yes), the example buffer circuitry 308 modifies the circuitry logic by adding a number of buffers. (Block 912). The number of buffers may be any value. In some examples, the number of buffers may depend on the total amount of conducting material within the IC package 108 that implements the identified node of block 902.

The example buffer circuitry 308 modifies the circuitry logic by connecting the identified node to the one or more buffers. (Block 914). If multiple buffers are added, the example buffer circuitry 308 may connect the identified node to a first buffer and connect the first buffer to the remaining buffers in series.

The example connector circuitry 310 modifies the circuitry logic by connecting the one or more buffers to the signal port. (Block 916). If multiple buffers are present, an end buffer exists that only has one connection before block 916. In such examples, the example connector circuitry 310 connects the signal port to the end buffer at block 916. As a result, the identified node and the signal port are electrically connected through the series of buffers.

The example layout planner circuitry 312 determines a circuit layout based on the modified circuitry logic. (Block 918). When determining the circuit layout, the example layout planner circuitry 312 may execute place and route software applications that use the modified circuitry logic to place a physical terminal in the identified elevated layer of block 904. When the IC package 108 is fabricated, the distance between the identified elevated layer of block 904 and the signal sensor circuitry 114 is sufficiently small that the identified node of block 902 can be accurately measured.

FIG. 10 is a block diagram of an example processor platform 1000 structured to execute and/or instantiate the machine readable instructions and/or the operations of FIG. 9 to implement the example designer circuitry 104 of FIG. 1. The processor platform 1000 can be, for example, a server, a personal computer, a workstation, a self-learning machine (e.g., a neural network), a mobile device (e.g., a cell phone, a smart phone, a tablet such as an iPad^{™}), an Internet appliance, or any other type of computing device.

The processor platform 1000 of the illustrated example includes processor circuitry 1012. The processor circuitry 1012 of the illustrated example is hardware. For example, the processor circuitry 1012 can be implemented by one or more integrated circuits, logic circuits, FPGAs, microprocessors, CPUs, GPUs, DSPs, and/or microcontrollers from any desired family or manufacturer. The processor circuitry 1012 may be implemented by one or more semiconductor based (e.g., silicon based) devices. In this example, the processor circuitry 1012 implements the interface circuitry 302, the identifier circuitry 304, the port adder circuitry 306, the buffer circuitry 308, the connector circuitry 310, and the layout planner circuitry 312.

The processor circuitry 1012 of the illustrated example includes a local memory 1013 (e.g., a cache, registers, etc.). The processor circuitry 1012 of the illustrated example is in communication with a main memory including a volatile memory 1014 and a non-volatile memory 1016 by a bus 1018. The volatile memory 1014 may be implemented by Synchronous Dynamic Random Access Memory (SDRAM), Dynamic Random Access Memory (DRAM), RAMBUS^{®} Dynamic Random Access Memory (RDRAM^{®}), and/or any other type of RAM device. The non-volatile memory 1016 may be implemented by flash memory and/or any other desired type of memory device. Access to the main memory 1014, 1016 of the illustrated example is controlled by a memory controller.

The processor platform 1000 of the illustrated example also includes interface circuitry 1020. The interface circuitry 1020 may be implemented by hardware in accordance with any type of interface standard, such as an Ethernet interface, a universal serial bus (USB) interface, a Bluetooth^{®} interface, a near field communication (NFC) interface, a Peripheral Component Interconnect (PCI) interface, and/or a Peripheral Component Interconnect Express (PCIe) interface.

In the illustrated example, one or more input devices 1022 are connected to the interface circuitry 1020. The input device(s) 1022 permit(s) a user to enter data and/or commands into the processor circuitry 1012. The input device(s) 1022 can be implemented by, for example, an audio sensor, a microphone, a camera (still or video), a keyboard, a button, a mouse, a touchscreen, a track-pad, a trackball, an isopoint device, and/or a voice recognition system.

One or more output devices 1024 are also connected to the interface circuitry 1020 of the illustrated example. The output device(s) 1024 can be implemented, for example, by display devices (e.g., a light emitting diode (LED), an organic light emitting diode (OLED), a liquid crystal display (LCD), a cathode ray tube (CRT) display, an in-place switching (IPS) display, a touchscreen, etc.), a tactile output device, a printer, and/or speaker. The interface circuitry 1020 of the illustrated example, thus, typically includes a graphics driver card, a graphics driver chip, and/or graphics processor circuitry such as a GPU.

The interface circuitry 1020 of the illustrated example also includes a communication device such as a transmitter, a receiver, a transceiver, a modem, a residential gateway, a wireless access point, and/or a network interface to facilitate exchange of data with external machines (e.g., computing devices of any kind) by a network 1026. The communication can be by, for example, an Ethernet connection, a digital subscriber line (DSL) connection, a telephone line connection, a coaxial cable system, a satellite system, a line-of-site wireless system, a cellular telephone system, an optical connection, etc.

The processor platform 1000 of the illustrated example also includes one or more mass storage devices 1028 to store software and/or data. Examples of such mass storage devices 1028 include magnetic storage devices, optical storage devices, floppy disk drives, HDDs, CDs, Blu-ray disk drives, redundant array of independent disks (RAID) systems, solid state storage devices such as flash memory devices and/or SSDs, and DVD drives.

The machine readable instructions 1032, which may be implemented by the machine readable instructions of FIG. 9, may be stored in the mass storage device 1028, in the volatile memory 1014, in the non-volatile memory 1016, and/or on a removable non-transitory computer readable storage medium such as a CD or DVD.

FIG. 11 is a block diagram of an example implementation of the processor circuitry 1012 of FIG. 10. In this example, the processor circuitry 1012 of FIG. 10 is implemented by a microprocessor 1100. For example, the microprocessor 1100 may be a general purpose microprocessor (e.g., general purpose microprocessor circuitry). The microprocessor 1100 executes some or all of the machine readable instructions of the flowcharts of FIGS. 8, 9 to effectively instantiate the designer circuitry 104 as logic circuits to perform the operations corresponding to those machine readable instructions. In some such examples, the designer circuitry 104 is instantiated by the hardware circuits of the microprocessor 1100 in combination with the instructions. For example, the microprocessor 1100 may be implemented by multi-core hardware circuitry such as a CPU, a DSP, a GPU, an XPU, etc. Although it may include any number of example cores 1102 (e.g., 1 core), the microprocessor 1100 of this example is a multi-core semiconductor device including N cores. The cores 1102 of the microprocessor 1100 may operate independently or may cooperate to execute machine readable instructions. For example, machine code corresponding to a firmware program, an embedded software program, or a software program may be executed by one of the cores 1102 or may be executed by multiple ones of the cores 1102 at the same or different times. In some examples, the machine code corresponding to the firmware program, the embedded software program, or the software program is split into threads and executed in parallel by two or more of the cores 1102. The software program may correspond to a portion or all of the machine readable instructions and/or operations represented by the flowcharts of FIGS. 8, 9.

The cores 1102 may communicate by a first example bus 1104. In some examples, the first bus 1104 may be implemented by a communication bus to effectuate communication associated with one(s) of the cores 1102. For example, the first bus 1104 may be implemented by at least one of an Inter-Integrated Circuit (I2C) bus, a Serial Peripheral Interface (SPI) bus, a PCI bus, or a PCIe bus. Additionally or alternatively, the first bus 1104 may be implemented by any other type of computing or electrical bus. The cores 1102 may obtain data, instructions, and/or signals from one or more external devices by example interface circuitry 1106. The cores 1102 may output data, instructions, and/or signals to the one or more external devices by the interface circuitry 1106. Although the cores 1102 of this example include example local memory 1120 (e.g., Level 1 (L1) cache that may be split into an L1 data cache and an L1 instruction cache), the microprocessor 1100 also includes example shared memory 1110 that may be shared by the cores (e.g., Level 2 (L2 cache)) for high-speed access to data and/or instructions. Data and/or instructions may be transferred (e.g., shared) by writing to and/or reading from the shared memory 1110. The local memory 1120 of each of the cores 1102 and the shared memory 1110 may be part of a hierarchy of storage devices including multiple levels of cache memory and the main memory (e.g., the main memory 1014, 1016 of FIG. 10). Typically, higher levels of memory in the hierarchy exhibit lower access time and have smaller storage capacity than lower levels of memory. Changes in the various levels of the cache hierarchy are managed (e.g., coordinated) by a cache coherency policy.

Each core 1102 may be referred to as a CPU, DSP, GPU, etc., or any other type of hardware circuitry. Each core 1102 includes control unit circuitry 1114, arithmetic and logic (AL) circuitry (sometimes referred to as an ALU) 1116, a plurality of registers 1118, the local memory 1120, and a second example bus 1122. Other structures may be present. For example, each core 1102 may include vector unit circuitry, single instruction multiple data (SIMD) unit circuitry, load/store unit (LSU) circuitry, branch/jump unit circuitry, floating-point unit (FPU) circuitry, etc. The control unit circuitry 1114 includes semiconductor-based circuits structured to control (e.g., coordinate) data movement within the corresponding core 1102. The AL circuitry 1116 includes semiconductor-based circuits structured to perform one or more mathematic and/or logic operations on the data within the corresponding core 1102. The AL circuitry 1116 of some examples performs integer based operations. In other examples, the AL circuitry 1116 also performs floating point operations. In yet other examples, the AL circuitry 1116 may include first AL circuitry that performs integer based operations and second AL circuitry that performs floating point operations. In some examples, the AL circuitry 1116 may be referred to as an Arithmetic Logic Unit (ALU). The registers 1118 are semiconductor-based structures to store data and/or instructions such as results of one or more of the operations performed by the AL circuitry 1116 of the corresponding core 1102. For example, the registers 1118 may include vector register(s), SIMD register(s), general purpose register(s), flag register(s), segment register(s), machine specific register(s), instruction pointer register(s), control register(s), debug register(s), memory management register(s), machine check register(s), etc. The registers 1118 may be arranged in a bank as shown in FIG. 11. Alternatively, the registers 1118 may be organized in any other arrangement, format, or structure including distributed throughout the core 1102 to shorten access time. The second bus 1122 may be implemented by at least one of an I2C bus, a SPI bus, a PCI bus, or a PCIe bus

Each core 1102 and/or, more generally, the microprocessor 1100 may include additional and/or alternate structures to those shown and described above. For example, one or more clock circuits, one or more power supplies, one or more power gates, one or more cache home agents (CHAs), one or more converged/common mesh stops (CMSs), one or more shifters (e.g., barrel shifter(s)) and/or other circuitry may be present. The microprocessor 1100 is a semiconductor device fabricated to include many transistors interconnected to implement the structures described above in one or more integrated circuits (ICs) contained in one or more packages. The processor circuitry may include and/or cooperate with one or more accelerators. In some examples, accelerators are implemented by logic circuitry to perform certain tasks more quickly and/or efficiently than can be done by a general purpose processor. Examples of accelerators include ASICs and FPGAs such as those discussed herein. A GPU or other programmable device can also be an accelerator. Accelerators may be on-board the processor circuitry, in the same chip package as the processor circuitry and/or in one or more separate packages from the processor circuitry.

FIG. 12 is a block diagram of another example implementation of the processor circuitry 1012 of FIG. 10. In this example, the processor circuitry 1012 is implemented by FPGA circuitry 1200. For example, the FPGA circuitry 1200 may be implemented by an FPGA. The FPGA circuitry 1200 can be used, for example, to perform operations that could otherwise be performed by the example microprocessor 1100 of FIG. 11 executing corresponding machine readable instructions. However, once configured, the FPGA circuitry 1200 instantiates the machine readable instructions in hardware and, thus, can often execute the operations faster than they could be performed by a general purpose microprocessor executing the corresponding software.

More specifically, in contrast to the microprocessor 1100 of FIG. 11 described above (which is a general purpose device that may be programmed to execute some or all of the machine readable instructions represented by the flowcharts of FIGS. 8, 9 but whose interconnections and logic circuitry are fixed once fabricated), the FPGA circuitry 1200 of the example of FIG. 12 includes interconnections and logic circuitry that may be configured and/or interconnected in different ways after fabrication to instantiate, for example, some or all of the machine readable instructions represented by the flowcharts of FIGS. 8, 9. In particular, the FPGA circuitry 1200 may be thought of as an array of logic gates, interconnections, and switches. The switches can be programmed to change how the logic gates are interconnected by the interconnections, effectively forming one or more dedicated logic circuits (unless and until the FPGA circuitry 1200 is reprogrammed). The configured logic circuits enable the logic gates to cooperate in different ways to perform different operations on data received by input circuitry. Those operations may correspond to some or all of the software represented by the flowcharts of FIGS. 8, 9. As such, the FPGA circuitry 1200 may be structured to effectively instantiate some or all of the machine readable instructions of the flowcharts of FIGS. 8, 9 as dedicated logic circuits to perform the operations corresponding to those software instructions in a dedicated manner analogous to an ASIC. Therefore, the FPGA circuitry 1200 may perform the operations corresponding to the some or all of the machine readable instructions of FIG. 9 faster than the general purpose microprocessor can execute the same.

In the example of FIG. 12, the FPGA circuitry 1200 is structured to be programmed (and/or reprogrammed one or more times) by an end user by a hardware description language (HDL) such as Verilog. The FPGA circuitry 1200 of FIG. 12, includes example input/output (I/O) circuitry 1202 to obtain and/or output data to/from example configuration circuitry 1204 and/or external hardware 1206. For example, the configuration circuitry 1204 may be implemented by interface circuitry that may obtain machine readable instructions to configure the FPGA circuitry 1200, or portion(s) thereof. In some such examples, the configuration circuitry 1204 may obtain the machine readable instructions from a user, a machine (e.g., hardware circuitry (e.g., programmed or dedicated circuitry) that may implement an Artificial Intelligence/Machine Learning (AI/ML) model to generate the instructions), etc. In some examples, the external hardware 1206 may be implemented by external hardware circuitry. For example, the external hardware 1206 may be implemented by the microprocessor 1100 of FIG. 11. The FPGA circuitry 1200 also includes an array of example logic gate circuitry 1208, a plurality of example configurable interconnections 1210, and example storage circuitry 1212. The logic gate circuitry 1208 and the configurable interconnections 1210 are configurable to instantiate one or more operations that may correspond to at least some of the machine readable instructions of FIG. 9 and/or other desired operations. The logic gate circuitry 1208 shown in FIG. 12 is fabricated in groups or blocks. Each block includes semiconductor-based electrical structures that may be configured into logic circuits. In some examples, the electrical structures include logic gates (e.g., And gates, Or gates, Nor gates, etc.) that provide basic building blocks for logic circuits. Electrically controllable switches (e.g., transistors) are present within each of the logic gate circuitry 1208 to enable configuration of the electrical structures and/or the logic gates to form circuits to perform desired operations. The logic gate circuitry 1208 may include other electrical structures such as look-up tables (LUTs), registers (e.g., flip-flops or latches), multiplexers, etc.

The configurable interconnections 1210 of the illustrated example are conductive pathways, traces, vias, or the like that may include electrically controllable switches (e.g., transistors) whose state can be changed by programming (e.g., using an HDL instruction language) to activate or deactivate one or more connections between one or more of the logic gate circuitry 1208 to program desired logic circuits.

The storage circuitry 1212 of the illustrated example is structured to store result(s) of the one or more of the operations performed by corresponding logic gates. The storage circuitry 1212 may be implemented by registers or the like. In the illustrated example, the storage circuitry 1212 is distributed amongst the logic gate circuitry 1208 to facilitate access and increase execution speed.

The example FPGA circuitry 1200 of FIG. 12 also includes example Dedicated Operations Circuitry 1214. In this example, the Dedicated Operations Circuitry 1214 includes special purpose circuitry 1216 that may be invoked to implement commonly used functions to avoid the need to program those functions in the field. Examples of such special purpose circuitry 1216 include memory (e.g., DRAM) controller circuitry, PCIe controller circuitry, clock circuitry, transceiver circuitry, memory, and multiplier-accumulator circuitry. Other types of special purpose circuitry may be present. In some examples, the FPGA circuitry 1200 may also include example general purpose programmable circuitry 1218 such as an example CPU 1220 and/or an example DSP 1222. Other general purpose programmable circuitry 1218 may additionally or alternatively be present such as a GPU, an XPU, etc., that can be programmed to perform other operations.

Although FIGS. 10 and 11 illustrate two example implementations of the processor circuitry 1012 of FIG. 10, many other approaches are contemplated. For example, as mentioned above, modern FPGA circuitry may include an on-board CPU, such as one or more of the example CPU 1220 of FIG. 12. Therefore, the processor circuitry 1012 of FIG. 10 may additionally be implemented by combining the example microprocessor 1100 of FIG. 11 and the example FPGA circuitry 1200 of FIG. 12. In some such hybrid examples, a first portion of the machine readable instructions represented by the flowcharts of FIGS. 8, 9 may be executed by one or more of the cores 1102 of FIG. 11, a second portion of the machine readable instructions represented by the flowcharts of FIGS. 8, 9 may be executed by the FPGA circuitry 1200 of FIG. 12, and/or a third portion of the machine readable instructions represented by the flowcharts of FIGS. 8, 9 may be executed by an ASIC. It should be understood that some or all of the circuitry of FIG. 2 may, thus, be instantiated at the same or different times. Some or all of the circuitry may be instantiated, for example, in one or more threads executing concurrently and/or in series. Moreover, in some examples, some or all of the circuitry of FIG. 2 may be implemented within one or more virtual machines and/or containers executing on the microprocessor.

In some examples, the processor circuitry 1012 of FIG. 10 may be in one or more packages. For example, the microprocessor 1100 of FIG. 11 and/or the FPGA circuitry 1200 of FIG. 12 may be in one or more packages. In some examples, an XPU may be implemented by the processor circuitry 1012 of FIG. 10, which may be in one or more packages. For example, the XPU may include a CPU in one package, a DSP in another package, a GPU in yet another package, and an FPGA in still yet another package.

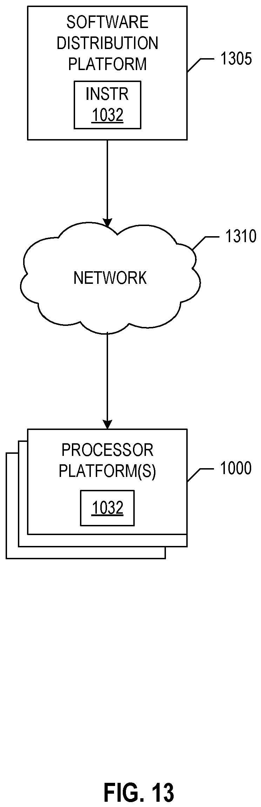

A block diagram illustrating an example software distribution platform 1305 to distribute software such as the example machine readable instructions 1032 of FIG. 10 to hardware devices owned and/or operated by third parties is illustrated in FIG. 13. The example software distribution platform 1305 may be implemented by any computer server, data facility, cloud service, etc., capable of storing and transmitting software to other computing devices. The third parties may be customers of the entity owning and/or operating the software distribution platform 1305. For example, the entity that owns and/or operates the software distribution platform 1305 may be a developer, a seller, and/or a licensor of software such as the example machine readable instructions 1032 of FIG. 10. The third parties may be consumers, users, retailers, OEMs, etc., who purchase and/or license the software for use and/or re-sale and/or sub-licensing. In the illustrated example, the software distribution platform 1305 includes one or more servers and one or more storage devices. The storage devices store the machine readable instructions 1032, which may correspond to the example machine readable instructions 800 of FIG. 8, as described above. The one or more servers of the example software distribution platform 1305 are in communication with an example network 1310, which may correspond to any one or more of the Internet and/or any example networks described above. In some examples, the one or more servers are responsive to requests to transmit the software to a requesting party as part of a commercial transaction. Payment for the delivery, sale, and/or license of the software may be handled by the one or more servers of the software distribution platform and/or by a third party payment entity. The servers enable purchasers and/or licensors to download the machine readable instructions 1032 from the software distribution platform 1305. For example, the software, which may correspond to the example machine readable instructions 800 of FIG. 8, may be downloaded to the example processor platform 1000, which is to execute the machine readable instructions 1032 to implement the designer circuitry 104. In some examples, one or more servers of the software distribution platform 1305 periodically offer, transmit, and/or force updates to the software (e.g., the example machine readable instructions 1032 of FIG. 10) to ensure improvements, patches, updates, etc., are distributed and applied to the software at the end user devices.

From the foregoing, it will be appreciated that example systems, methods, apparatus, and articles of manufacture have been disclosed that elevate signals in ICs. Disclosed systems, methods, apparatus, and articles of manufacture improve the efficiency of using a computing device by extending an interconnect into a layer of an IC that is sufficiently close for a sensor to a) record accurate measurements of the corresponding node and b) generate debugging and verification information. Disclosed systems, methods, apparatus, and articles of manufacture are accordingly directed to one or more improvement(s) in the operation of a machine such as a computer or other electronic and/or mechanical device.

Example methods, apparatus, systems, and articles of manufacture to elevate nodes are disclosed herein. Further examples and combinations thereof include the following.

Example 1 includes an apparatus to elevate nodes, the apparatus comprising interface circuitry to obtain circuitry logic, the circuitry logic including a plurality of circuit elements logically connected by a plurality of nodes, and processor circuitry including one or more of at least one of a central processor unit, a graphics processor unit, or a digital signal processor, the at least one of the central processor unit, the graphics processor unit, or the digital signal processor having control circuitry to control data movement within the processor circuitry, arithmetic and logic circuitry to perform one or more first operations corresponding to instructions, and one or more registers to store a result of the one or more first operations, the instructions in the apparatus, a Field Programmable Gate Array (FPGA), the FPGA including logic gate circuitry, a plurality of configurable interconnections, and storage circuitry, the logic gate circuitry and the plurality of the configurable interconnections to perform one or more second operations, the storage circuitry to store a result of the one or more second operations, or Application Specific Integrated Circuitry (ASIC) including logic gate circuitry to perform one or more third operations, the processor circuitry to perform at least one of the first operations, the second operations, or the third operations to instantiate identifier circuitry to identify a node within the plurality of nodes for elevation, and identify a layer of an integrated circuit, port adder circuitry to modify the circuitry logic by adding a signal port, the signal port corresponding to a physical terminal in the identified layer, connector circuitry to modify the circuitry logic by connecting the signal port to the identified node, and layout planner circuitry to determine a layout of the integrated circuit based on the modified circuitry logic.

Example 2 includes the apparatus of example 1, wherein signal sensor circuitry separate from the apparatus is to detect the identified node using the physical terminal, and determine debugging information based on electrical characteristics of the identified node.

Example 3 includes the apparatus of example 2, wherein the identified layer is a first layer of the integrated circuit, the signal sensor circuitry is to detect the identified node implemented in the first layer, the signal sensor circuitry is unable to detect a second node implemented in a second layer of the integrated circuit, the second layer further from the signal sensor circuitry than the first layer, and the modified circuitry logic causes the layout planner circuitry to extend the identified node through the second layer and into the first layer.

Example 4 includes the apparatus of example 2, wherein the integrated circuit is fabricated with backside power delivery.

Example 5 includes the apparatus of example 4, wherein the integrated circuit includes a wafer, the wafer having a front side and a back side, the identified node is part of a power delivery network, the power delivery network implemented on the back side of the wafer, the signal sensor circuitry can detect nodes on the front side of the wafer, and the modified circuitry logic causes the layout planner circuitry to extend the identified node from the back side of the wafer to the front side of the wafer.

Example 6 includes the apparatus of example 1, further including buffer circuitry to modify the circuitry logic by adding a buffer, and connecting the identified node to the buffer, wherein the connector circuitry is to modify the circuitry logic by connecting the buffer to the signal port.

Example 7 includes the apparatus of example 6, wherein the identified node connects two circuit elements in a child circuit, the integrated circuit includes the child circuit and a parent circuit, the child circuit designed separately from the parent circuit, the physical terminal is in a layer of the integrated circuit that implements the parent circuit, and the buffer electrically isolates the child circuit from the parent circuit.

Example 8 includes the apparatus of example 6, wherein the buffer circuitry is further to determine whether to add the buffer, the determination based on at least one of a) a type of signal sensor, b) a die size of the integrated circuit, c) a cost of the integrated circuit, or d) whether the integrated circuit may be implemented as a child circuit.

Example 9 includes an apparatus to elevate nodes, the apparatus comprising at least one memory, machine readable instructions, and processor circuitry to at least one of instantiate or execute the machine readable instructions to obtain circuitry logic, the circuitry logic including a plurality of circuit elements logically connected by a plurality of nodes, identify a node within the plurality of nodes for elevation, identify a layer of an integrated circuit, modify the circuitry logic by adding a signal port, the signal port corresponding to a physical terminal in the identified layer, modify the circuitry logic by connecting the signal port to the identified node, and determine a layout of the integrated circuit based on the modified circuitry logic.

Example 10 includes the apparatus of example 9, further including signal sensor circuitry separate from the processor circuitry to detect the identified node using the physical terminal, and determine debugging information based on electrical characteristics of the identified node.

Example 11 includes the apparatus of example 10, wherein the identified layer is a first layer of the integrated circuit, the signal sensor circuitry is to detect the identified node from the first layer, the signal sensor circuitry is unable to detect a second node implemented in a second layer of the integrated circuit, the second layer located further from the signal sensor circuitry than the first layer, and the machine readable instructions cause the processor circuitry to extend the identified node through the second layer and into the first layer based on the modified circuitry logic.

Example 12 includes the apparatus of example 10, wherein the integrated circuit is fabricated with backside power delivery.

Example 13 includes the apparatus of example 12, wherein the integrated circuit includes a wafer, the wafer having a front side and a back side, the identified node is part of a power delivery network, the power delivery network implemented on the backside of the wafer, the signal sensor circuitry can detect nodes on the front side of the wafer, and the machine readable instructions cause the processor circuitry to extend the identified node from the back side of the wafer to the front side of the wafer.

Example 14 includes the apparatus of example 9, wherein the machine readable instructions cause the processor circuitry to modify the circuitry logic by adding a buffer, connecting the identified node to the buffer, and connecting the buffer to the signal port.

Example 15 includes the apparatus of example 14, wherein the identified node connects two circuit elements in a child circuit, the integrated circuit includes the child circuit and a parent circuit, the child circuit designed separately from the parent circuit, the physical terminal is in a layer of the integrated circuit that implements the parent circuit, and the buffer electrically isolates the child circuit from the parent circuit.

Example 16 includes the apparatus of example 14, wherein the machine readable instructions cause the processor circuitry to determine whether to add the buffer, the determination based on at least one of a) a type of signal sensor, b) a die size of the integrated circuit, c) a cost of the integrated circuit, or d) whether the integrated circuit may be implemented as a child circuit.

Example 17 includes a method to elevate nodes, the method comprising obtaining circuitry logic, the circuitry logic including a plurality of circuit elements logically connected by a plurality of nodes, identifying a node within the plurality of nodes for elevation, identifying a layer of an integrated circuit, modifying the circuitry logic by adding a signal port, the signal port corresponding to a physical terminal in the identified layer, modifying the circuitry logic by connecting the signal port to the identified node, and determining a layout of the integrated circuit based on the modified circuitry logic.

Example 18 includes the method of example 17, further including detecting the identified node using the physical terminal, and determining debugging information based on electrical characteristics of the identified node.

Example 19 includes the method of example 18, wherein the identified layer is a first layer of the integrated circuit, and the method further includes detecting, with signal sensor circuitry, the identified node from the first layer, and extending the identified node through a second layer of the integrated circuit and into the first layer, the second layer located further from the signal sensor circuitry than the first layer, the signal sensor circuitry unable to detect the identified node in the second layer.

Example 20 includes the method of example 18, further including fabricating the integrated circuit with backside power delivery.

Example 21 includes the method of example 20, wherein the integrated circuit includes a wafer, the wafer having a front side and a back side, the identified node is part of a power delivery network, the power delivery network implemented on the backside of the wafer, the method further includes detecting, with the signal sensor circuitry, nodes on the front side of the wafer, and extending the identified node from the back side of the wafer to the front side of the wafer.

Example 22 includes the method of example 17, wherein the method further includes modifying the circuitry logic by adding a buffer, connecting the identified node to the buffer, and connecting the buffer to the signal port.

Example 23 includes the method of example 22, wherein the identified node connects two circuit elements in a child circuit, the integrated circuit includes the child circuit and a parent circuit, the child circuit designed separately from the parent circuit, the physical terminal is in a layer of the integrated circuit that implements the parent circuit, and the buffer electrically isolates the child circuit from the parent circuit.

Example 24 includes the method of example 22, further including determining whether to add the buffer, the determination based on at least one of a) a type of signal sensor, b) a die size of the integrated circuit, c) a cost of the integrated circuit, or d) whether the integrated circuit may be implemented as a child circuit.

Example 25 includes an apparatus to elevate nodes, the apparatus comprising means for obtaining circuitry logic, the circuitry logic including a plurality of circuit elements logically connected by a plurality of nodes, means for identifying to identify a node within the plurality of nodes for elevation, and identify a layer of an integrated circuit, means for adding a signal port to the circuitry logic, the signal port corresponding to a physical terminal in the identified layer, means for connecting, in the circuitry logic, the signal port to the identified node, and means for determining a layout of the integrated circuit based on modified circuitry logic.

Example 26 includes the apparatus of example 25, wherein means for sensing separate from the apparatus is to detect the identified node using the physical terminal, and determine debugging information based on electrical characteristics of the identified node.

Example 27 includes the apparatus of example 26, wherein the identified layer is a first layer of the integrated circuit, the means for sensing is to detect the identified node implemented in the first layer, the means for sensing is unable to detect a second node implemented in a second layer of the integrated circuit, the second layer further from the means for sensing than the first layer, and the modified circuitry logic causes the means for determining a layout to extend the identified node through the second layer and into the first layer.

Example 28 includes the apparatus of example 26, wherein the integrated circuit is fabricated with backside power delivery.

Example 29 includes the apparatus of example 28, wherein the integrated circuit includes a wafer, the wafer having a front side and a back side, the identified node is part of a power delivery network, the power delivery network implemented on the backside of the wafer, the means for sensing can detect nodes on the front side of the wafer, and the modified circuitry logic causes the means for determining a layout to extend the identified node from the back side of the wafer to the front side of the wafer.

Example 30 includes the apparatus of example 25, further including means for buffering to add a buffer to the circuitry logic, and connect the identified node to the buffer, wherein the means for connecting is to connect, in the circuitry logic, the buffer to the signal port.

Example 31 includes the apparatus of example 30, wherein the identified node connects two circuit elements in a child circuit, the integrated circuit includes the child circuit and a parent circuit, the child circuit designed separately from the parent circuit, the physical terminal is in a layer of the integrated circuit that implements the parent circuit, and the buffer electrically isolates the child circuit from the parent circuit.

Example 32 includes the apparatus of example 30, wherein the means for buffering is further to determine whether to add the buffer, the determination based on at least one of a) a type of signal sensor, b) a die size of the integrated circuit, c) a cost of the integrated circuit, or d) whether the integrated circuit may be implemented as a child circuit.

The following claims are hereby incorporated into this Detailed Description by this reference. Although certain example systems, methods, apparatus, and articles of manufacture have been disclosed herein, the scope of coverage of this patent is not limited thereto. On the contrary, this patent covers all systems, methods, apparatus, and articles of manufacture fairly falling within the scope of the claims of this patent.

## Claims

1. An apparatus to elevate nodes, the apparatus comprising:
interface circuitry to obtain circuitry logic, the circuitry logic describing a plurality of circuit elements logically connected by a plurality of nodes;
computer readable instructions; and
programmable circuitry to instantiate:
identifier circuitry to:
identify a node within the plurality of nodes for elevation; and
identify a layer of an integrated circuit;
port adder circuitry to modify the circuitry logic by adding a signal port, the signal port corresponding to a physical terminal in the identified layer;
connector circuitry to modify the circuitry logic by connecting the signal port to the identified node; and
layout planner circuitry to determine a layout of the integrated circuit based on the modified circuitry logic.

2. The apparatus of claim 1, wherein signal sensor circuitry separate from the apparatus is to:
detect the identified node using the physical terminal; and
determine debugging information based on electrical characteristics of the identified node.

3. The apparatus of claims 1 and 2, wherein:
the identified layer is a first layer of the integrated circuit;
the signal sensor circuitry is to detect the identified node implemented in the first layer;
the signal sensor circuitry is unable to detect a second node implemented in a second layer of the integrated circuit, the second layer further from the signal sensor circuitry than the first layer; and
the modified circuitry logic causes the layout planner circuitry to extend the identified node through the second layer and into the first layer.

4. The apparatus of claims 1 and 2, wherein the integrated circuit is fabricated with backside power delivery.

5. The apparatus of claims 1 and 4, wherein:
the integrated circuit includes a wafer, the wafer having a front side and a back side;
the identified node is part of a power delivery network, the power delivery network implemented on the back side of the wafer;
the signal sensor circuitry can detect nodes on the front side of the wafer; and
the modified circuitry logic causes the layout planner circuitry to extend the identified node from the back side of the wafer to the front side of the wafer.

6. The apparatus of claim 1, further including buffer circuitry to modify the circuitry logic by:
adding a buffer; and
connecting the identified node to the buffer, wherein the connector circuitry is to modify the circuitry logic by connecting the buffer to the signal port.

7. The apparatus of claims 1 and 6, wherein:
the identified node connects two circuit elements in a child circuit;
the integrated circuit includes the child circuit and a parent circuit, the child circuit designed separately from the parent circuit;
the physical terminal is in a layer of the integrated circuit that implements the parent circuit;
and
the buffer electrically isolates the child circuit from the parent circuit.

8. The apparatus of claims 1 and 6, wherein the buffer circuitry is further to determine whether to add the buffer, the determination based on at least one of: a) a type of signal sensor, b) a die size of the integrated circuit, c) a cost of the integrated circuit, or d) whether the integrated circuit may be implemented as a child circuit.

9. A method to elevate nodes, the method comprising:
obtaining circuitry logic, the circuitry logic describing a plurality of circuit elements logically connected by a plurality of nodes;
identifying a node within the plurality of nodes for elevation;
identifying a layer of an integrated circuit;
modifying, by executing an instruction with programmable circuitry, the circuitry logic by adding a signal port, the signal port corresponding to a physical terminal in the identified layer;
modifying the circuitry logic by connecting the signal port to the identified node; and
determining a layout of the integrated circuit based on the modified circuitry logic.

10. The method of claim 9, further including:
detecting the identified node using the physical terminal; and
determining debugging information based on electrical characteristics of the identified node.

11. The method of claims 9 and 10, wherein:
the identified layer is a first layer of the integrated circuit; and
the method further includes:
detecting, with signal sensor circuitry, the identified node from the first layer; and
extending the identified node through a second layer of the integrated circuit and into the first layer, the second layer located further from the signal sensor circuitry than the first layer, the signal sensor circuitry unable to detect the identified node in the second layer.

12. The method of claims 9 and 10, further including fabricating the integrated circuit with backside power delivery.

13. The method of claims 9 and 12, wherein:
the integrated circuit includes a wafer, the wafer having a front side and a back side;
the identified node is part of a power delivery network, the power delivery network implemented on the backside of the wafer;
the method further includes:
detecting nodes on the front side of the wafer; and
extending the identified node from the back side of the wafer to the front side of the wafer.

14. The method of claim 9, wherein the method further includes modifying the circuitry logic by:
adding a buffer;
connecting the identified node to the buffer; and
connecting the buffer to the signal port.

15. Machine-readable storage including machine-readable instructions, when executed, to implement a method or realize an apparatus as claimed in any preceding claim.
